# EUROPEAN PATENT APPLICATION

(11) **EP 4 770 321 A1**
(43) Date of publication of application: **01.07.2026**
(21) Application number: 25191313.3
(22) Date of filing: 23.07.2025
(51) Int. Cl.: H10D 30/66, H10D 64/60, H10D 62/10, H10D 64/23

(54) **SEMICONDUCTOR DEVICE**

(30) Priority: 26.12.2024 KR 20240197476
(71) Applicant: Samsung Electronics Co., Ltd., Suwon-si, Gyeonggi-do 16677 (KR)
(72) Inventor: KIM, Taehun, Suwon-si (KR); WOO, Sangsu, Suwon-si (KR); PARK, Young Hwan, Suwon-si (KR); PARK, Jeonghwan, Suwon-si (KR); OH, Sewoong, Suwon-si (KR)
(74) Representative: Marks & Clerk LLP

(57) **Abstract**

A semiconductor device includes a substrate including a cell region and a peripheral region outside the cell region, a first conductivity type semiconductor layer on an upper surface of the substrate, a second conductivity type doped well region within the first conductivity type semiconductor layer, a gate electrode on the first conductivity type semiconductor layer, a gate insulation layer between the first conductivity type semiconductor layer and the gate electrode, a source electrode on the second conductivity type doped well region, and a drain electrode below the substrate. The source electrode includes a first source electrode on the gate electrode, a second source electrode on the first source electrode, and an interlayer source electrode including insulation structures spaced apart in a first direction parallel to the upper surface and conductive lines between the insulation structures, and disposed between the first source electrode and the second source electrode.

## Description

### BACKGROUND

In modern society, semiconductor devices are closely related to daily life. In particular, the importance of power semiconductor devices used in various fields such as transportation fields such as electric vehicles, railroads, and electric trams, renewable energy systems such as solar power generation and wind power generation, and mobile devices is gradually increasing. Power semiconductor devices may be semiconductor devices used to handle high voltage or high current, and perform functions such as power conversion and control in large power systems or high-output electronic devices. In some instances, power semiconductor devices may have the ability and durability to handle high power, and they may handle large amounts of current and withstand high voltage. For example, power semiconductor devices may handle voltages from hundreds of volts to thousands of volts and currents from tens of amperes to thousands of amperes. Power semiconductor devices may improve the efficiency of electrical energy by minimizing power loss. Additionally, power semiconductor devices may be stably driven even in environments such as high temperatures.

These power semiconductor devices may be classified according to materials, and examples may include SiC power semiconductor devices and GaN power semiconductor devices. In some examples, power semiconductor devices may be manufactured using SiC or GaN instead of existing silicon wafer (Si wafer), and may compensate the disadvantage of silicon, which may exhibit unstable characteristics at high temperatures. The SiC power semiconductor devices may be resistant to high temperatures and may have low power loss, and may be suitable for electric vehicles, renewable energy systems, etc. The GaN power semiconductor devices may come with high costs, but they may offer efficiency in terms of speed and may be suitable for highspeed charging of mobile devices.

### SUMMARY

In general, in some aspects, the present disclosure provides a semiconductor device capable of preventing a short-circuit by reducing saturation drain current (Idₛₐₜ) without changing on-state drain-source resistance (Rdsₒₙ), without changing a structure in the active source contact region, such as changing the channel length, and without adding additional resistance outside the circuit (e.g., a package or a module), and capable of lowering the current concentration at the active source contact and improving voltage overshooting or non-uniformity of the source current by a cell region location to improve current spreading.

In general, in some aspects, the present disclosure provides a semiconductor device that includes a substrate including a cell region and a peripheral region located outside the cell region, a first conductivity type semiconductor layer on an upper surface of the substrate, a second conductivity type doped well region within the first conductivity type semiconductor layer, a gate electrode on the first conductivity type semiconductor layer, a gate insulation layer between the first conductivity type semiconductor layer and the gate electrode, a source electrode on the second conductivity type doped well region, and a drain electrode under a lower surface of the substrate, where the source electrode includes a first source electrode on the gate electrode, a second source electrode on the first source electrode, and an interlayer source electrode comprising insulation structures spaced apart in a first direction parallel to the upper surface of the substrate and conductive lines between the insulation structures, and disposed between the first source electrode and the second source electrode.

In general, in some aspects, the present disclosure provides a semiconductor device that includes a substrate including a cell region and a peripheral region located outside the cell region, a first conductivity type semiconductor layer on an upper surface of the substrate, a second conductivity type doped well region within the first conductivity type semiconductor layer, a gate electrode on the first conductivity type semiconductor layer, a gate insulation layer between the first conductivity type semiconductor layer and the gate electrode, a source electrode on the second conductivity type doped well region, and a drain electrode under a lower surface of the substrate, where the source electrode includes a first source electrode on the gate electrode, a second source electrode on the first source electrode, and an interlayer source electrode comprising insulation structures spaced apart in a first direction parallel to the upper surface of the substrate and conductive lines between the insulation structures, and disposed between the first source electrode and the second source electrode, the source electrode includes multiple layers of the second source electrodes and multiple layers of the interlayer source electrodes, and the second source electrodes and the interlayer source electrodes are alternately stacked in the third direction.

In general, in some aspects, the present disclosure provides a semiconductor device that includes a substrate including a cell region and a peripheral region located outside the cell region, a first conductivity type semiconductor layer on an upper surface of the substrate, a second conductivity type doped well region within the first conductivity type semiconductor layer, a gate electrode on the first conductivity type semiconductor layer, a gate insulation layer between the first conductivity type semiconductor layer and the gate electrode, a source electrode on the second conductivity type doped well region, and a drain electrode under a lower surface of the substrate, where the source electrode includes a first source electrode on the gate electrode, a 1st interlayer source electrode disposed on the first source electrode and including insulation structures spaced apart in a first direction parallel to the upper surface of the substrate and conductive lines disposed between the insulation structures, a 1st second source electrode on the 1st interlayer source electrode, a 2nd interlayer source electrode disposed on the 1st second source electrode, and including insulation structures spaced apart in the first direction and conductive lines between the insulation structures, and a 2nd second source electrode on the 2nd interlayer source electrode, and center points of the insulation structures of the 1st interlayer source electrode along the first direction and the second direction, which are parallel to the upper surface of the substrate and different from the first direction, are not overlapped with center points of the insulation structures of the 2nd interlayer source electrode along the first direction and the second direction in the third direction perpendicular to the upper surface of the substrate.

The semiconductor device according to implementations may prevent a short-circuit by reducing a saturated drain current (Idₛₐₜ) without changing the drain/source on-resistance (Rdsₒₙ) and without changing the structure in an active source contact region, such as changing the channel length, without adding additional resistance outside the circuit (e.g., a package or module).

Additionally, the current spreading may be improved by reducing the current concentration of the active source contact and improving the voltage overshooting or non-uniformity of the source current by a cell region location.

At least some of the above and other features of the invention are set out in the claims.

### BRIEF DESCRIPTION OF THE DRAWINGS

FIG. 1 is a plan view showing a semiconductor device.
FIG. 2 is a cross-sectional view taken along line A-A' of FIG. 1.
FIG. 3 is a circuit diagram of a semiconductor device.
FIG. 4 is a cross-sectional view showing a semiconductor device, and is a drawing corresponding to FIG. 2.
FIG. 5 is a plan view showing a semiconductor device.
FIG. 6 is a plan view showing a semiconductor device.
FIG. 7 is a plan view showing a semiconductor device.
FIG. 8 is a cross-sectional view taken along line A-A' of FIG. 7.
FIG. 9 is a cross-sectional view taken along line B-B' of FIG. 7.
FIG. 10 is a plan view showing a semiconductor device.
FIG. 11 is a cross-sectional view taken along line A-A' of FIG. 10.
FIG. 12 is a plan view showing a semiconductor device.
FIG. 13 is a cross-sectional view taken along line A-A' of FIG. 12.
FIG. 14 is a plan view illustrating a 1st interlayer source electrode of a semiconductor device.
FIG. 15 is a plan view showing the 2nd interlayer source electrode of the semiconductor device of FIG. 14.
Fig. 16 is a plan view showing the 3rd interlayer source electrode of the semiconductor device of FIG. 14.
FIG. 17 is a cross-sectional view taken along line A-A' of FIG. 16.
FIG. 18 is a plan view showing a 1st interlayer source electrode of a semiconductor device.
FIG. 19 is a plan view showing the 2nd interlayer source electrode of the semiconductor device of FIG. 18.
FIG. 20 is a cross-sectional view taken along line A-A' of FIG. 19.
FIG. 21 is a cross-sectional view taken along line B-B' of FIG. 19.
FIG. 22 is a plan view illustrating a 1st interlayer source electrode of a semiconductor device.
FIG. 23 is a plan view showing the 2nd interlayer source electrode of the semiconductor device of FIG. 22.
FIG. 24 is a cross-sectional view taken along line A-A' of FIG. 23.
FIG. 25 is a cross-sectional view taken along line B-B' of FIG. 23.
FIG. 26 is a plan view illustrating a 1st interlayer source electrode of a semiconductor device.
FIG. 27 is a plan view showing the 2nd interlayer source electrode of the semiconductor device of FIG. 26.
FIG. 28 is a cross-sectional view taken along line A-A' of FIG. 27.
FIG. 29 is a cross-sectional view taken along line B-B' of FIG. 27.
FIG. 30 is a plan view showing a 1st interlayer source electrode of a semiconductor device.
FIG. 31 is a plan view showing the 2nd interlayer source electrode of the semiconductor device of FIG. 30.
FIG. 32 is a cross-sectional view taken along line A-A' of FIG. 31.
FIG. 33 is a cross-sectional view taken along line B-B' of FIG. 31.

### DETAILED DESCRIPTION

Hereinafter, various implementations of the present disclosure will be described in detail with reference to the attached drawings so that a person having ordinary skill in the art to which the present disclosure pertains can easily implement the present disclosure. The present disclosure may be embodied in many different forms and is not limited to the implementations set forth herein.

The drawings and description are to be regarded as illustrative in nature and not restrictive. Like reference numerals designate like elements throughout the specification.

The size and thickness of each constituent element as shown in the drawings are randomly indicated for better understanding and ease of description, and this disclosure is not necessarily limited to as shown. In the drawings, the thickness of layers, regions, etc., are exaggerated for clarity. In addition, in the drawings, for better understanding and ease of description, the thickness of some layers and areas is exaggerated. As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" may mean being disposed on or below the object portion, and does not necessarily mean being disposed on the upper side of the object portion based on a gravitational direction.

In addition, unless explicitly described to the contrary, the word "comprise," and variations such as "comprises" or "comprising," will be understood to imply the inclusion of stated elements but not the exclusion of any other elements. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements. Numerical labels, such as "first", "second", "third", etc. may be used to distinguish components from each other and do not limit the present disclosure. For example, the terms "first", "second", "third", etc. may not necessarily involve an order or a numerical meaning of any form. In addition, abbreviated numbering "1^{st}", "2^{nd}", "3^{rd}", etc. may be used interchangeably with non-abbreviated numbering "first", "second", "third", etc.

In addition, in this specification, the phrase "on a plane" means viewing a target portion from the top, and the phrase "on a cross-section" means viewing a cross-section formed by vertically cutting a target portion from the side.

Additionally, throughout the specification, two directions parallel to and perpendicular to the upper surface of the substrate are defined as a first direction D1 and a second direction D2, respectively, and the direction perpendicular to the upper surface of the substrate is described as a third direction D3. For example, the first direction D1 and the second direction D2 may be the length direction and the width direction, respectively, and the third direction D3 may be the thickness direction. The third direction D3 may be a vertical direction (e.g. for the purposes of defining relative vertical positions or heights). Accordingly, an element that is described as being above another element may be located further along the third direction D3. It will be appreciated that these directions and positions are defined relative to the structure of the device, and need not imply any particular orientation of the device in use.

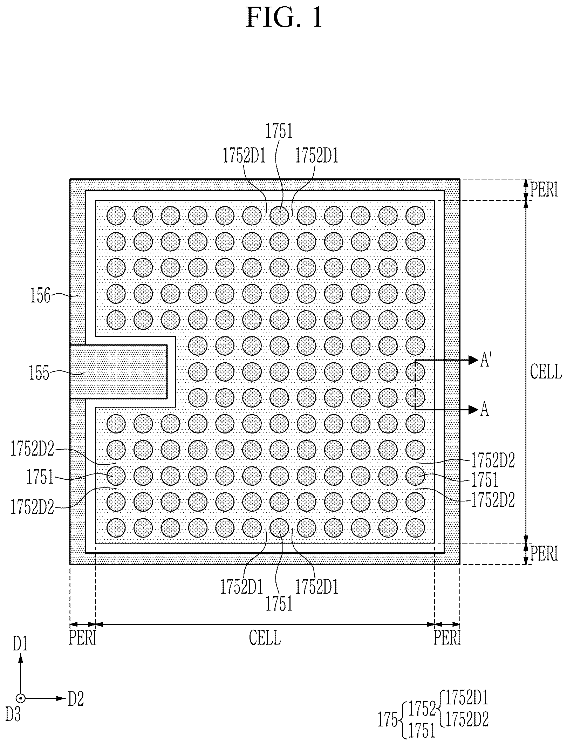

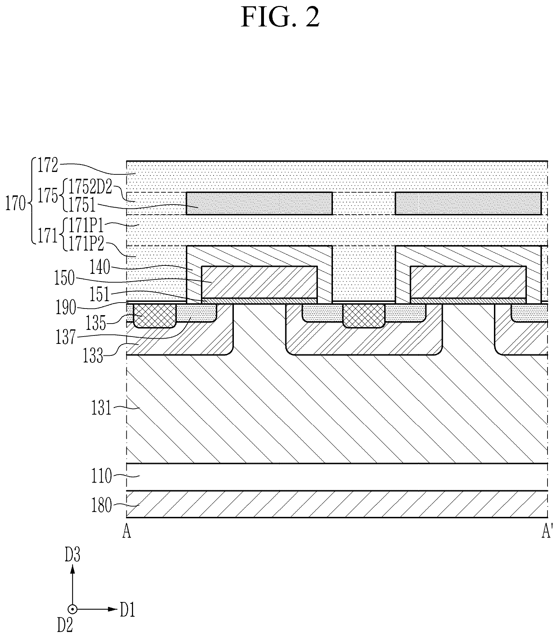

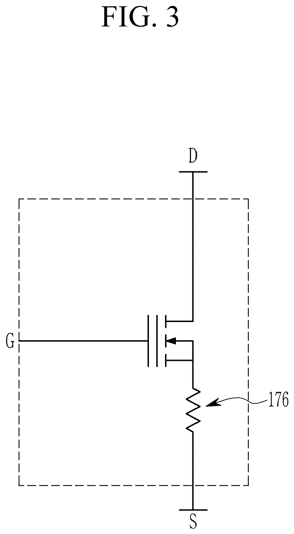

FIG. 1 is a plan view showing a semiconductor device according to some implementations. FIG. 2 is a cross-sectional view taken along line A-A' of FIG. 1. FIG. 3 is a circuit diagram of a semiconductor device according to some implementations.

For a clear understanding and simple illustration, FIG. 1 mainly illustrates first conductive lines 1752D1, second conductive lines 1752D2, and insulation structures 1751 of an interlayer source electrode 175, a gate pad 155, and a gate wire 156, and the illustrations of a substrate 110, a first conductivity type semiconductor layer 131, a second conductivity type doped well region 133, a gate electrode 150, a gate insulation layer 151, a first source electrode 171 and the second source electrode 172 of the source electrode 170, and the drain electrode 180 are omitted.

Referring to FIGS. 1 to 3, a semiconductor device includes a substrate 110, a first conductivity type semiconductor layer 131 (e.g. a semiconductor layer having a first conductivity type) on an upper surface of the substrate 110, a second conductivity type doped well region 133 (e.g. a well region doped to have a second conductivity type) within the first conductivity type semiconductor layer 131, a gate electrode 150 on the first conductivity type semiconductor layer 131 and the second conductivity type doped well region 133, a gate insulation layer 151 between the first conductivity type semiconductor layer 131 and the gate electrode 150, a source electrode 170 on the second conductivity type doped well region 133, and a drain electrode 180 under a lower surface of the substrate 110.

The substrate 110 may include a cell region CELL and a peripheral region PERI surrounding the cell region CELL.

A first source electrode 171 of a source electrode 170 described later may be disposed on the cell region CELL. The first source electrode 171 may cover the cell region CELL. In other words, the cell region CELL may be completely overlapped with the first source electrode 171 in the third direction D3.

A gate pad 155 may be disposed on one side of the first source electrode 171 in the first direction D1 or the second direction D2. For example, the gate pad 155 may be disposed in the peripheral region PERI. Additionally, a gate wire 156 extending from the gate pad 155 may be disposed in the peripheral region PERI. The gate wire 156 may be extended to be disposed throughout the peripheral region PERI. In other words, the gate wire 156 may surround the cell region CELL.

As described below, the first source electrode 171 may extend downward in the third direction D3 to make an active source contact with the second conductivity type doped well region 133. The gate pad 155 and gate wire 156 are electrically contacted with the gate electrode 150.

The substrate 110 may be a semiconductor substrate including SiC. For example, the substrate 110 may be made of a 4H SiC substrate. In some cases, the substrate 110 may be made of a 3C SiC substrate, a 6H SiC substrate, etc. The substrate 110 may be doped with a first conductivity type impurity. For example, the first conductivity type impurity may be an n-type impurity. In other words, the substrate 110 may be doped with n type. The substrate 110 may be doped with n-type at a high concentration. The resistivity of the substrate 110 may be greater than or equal to about 0.005 Ω·cm and less than or equal to about 0.035 Ω·cm. A thickness of the substrate 110 may be greater than or equal to about 100 µm and less than or equal to about 700 µm. The material, doping type, doping concentration, resistivity, thickness, etc. of the substrate 110 are not limited thereto and may be changed in various ways. For instance, in an alternative embodiment the first doping type is p type and the second doping type is n type. The substrate 110 may have a first surface and a second surface facing away from (e.g. opposite) each other. The first surface of the substrate 110 may be the upper surface of the substrate 110, and the second surface of the substrate 110 may be the lower surface of the substrate 110.

The first conductivity type semiconductor layer 131 may be disposed on the first surface, i.e., the upper surface, of the substrate 110. The lower surface of the first conductivity type semiconductor layer 131 may be in contact with the upper surface of the substrate 110. However, it is not limited thereto, and another layer may be disposed between the substrate 110 and the first conductivity type semiconductor layer 131. The first conductivity type semiconductor layer 131 may be an epitaxial layer formed from the substrate 110 using an epitaxial growth method. The first conductivity type semiconductor layer 131 may include SiC. For example, the first conductivity type semiconductor layer 131 may include 4H SiC. The first conductivity type semiconductor layer 131 may be doped as n type. The first conductivity type semiconductor layer 131 may be doped as an n type at a low concentration. The doping concentration of the first conductivity type semiconductor layer 131 may be lower than the doping concentration of the substrate 110. The doping concentration of the first conductivity type semiconductor layer 131 may be greater than or equal to about 1×10¹⁵ cm⁻³ and less than or equal to about 1×10¹⁷ cm⁻³. A thickness of the first conductivity type semiconductor layer 131 may be greater than or equal to about 1 µm and less than or equal to about 13 µm. The material, doping type, doping concentration, etc. of the first conductivity type semiconductor layer 131 are not limited thereto and may be changed in various ways. For instance, in an alternative embodiment the first doping type is p type and the second doping type is n type.

The second conductivity type doped well region 133 may be disposed within the first conductivity type semiconductor layer 131. The second conductivity type doped well region 133 may be disposed on the first conductivity type semiconductor layer 131. The second conductivity type doped well region 133 may be in contact with the lower surface of the second conductivity type doped layer 135 described later. The second conductivity type doped well region 133 may surround the lower surface and side surface of the first conductivity type doped layer 137 described later. The second conductivity type may be different to the first conductivity type. For instance, the second conductivity type may be p type.

At least a portion of the upper surface of the second conductivity type doped well region 133 may be overlapped with at least a portion of the gate electrode 150 and at least a portion of the gate insulation layer 151 in the third direction D3.

The second conductivity type doped well region 133 may extend from the upper surface of the first conductivity type semiconductor layer 131 toward the lower surface of the first conductivity type semiconductor layer 131. That is, the second conductivity type doped well region 133 may extend in the third direction D3 from the upper surface of the first conductivity type semiconductor layer 131. The second conductivity type doped well region 133 may be formed in at least a portion of the first conductivity type semiconductor layer 131 through ion implantation.

The second conductivity type doped well region 133 may include SiC. For example, the second conductivity type doped well region 133 may include 4H SiC. The second conductivity type doped well region 133 may be doped with p type. The second conductivity type doped well region 133 may be doped as a p type at a low concentration (e.g. a lower concentration than the doping concentration of the substrate 110). The doping concentration of second conductivity type doped well region 133 may greater than the doping concentration of the first conductivity type semiconductor layer 131. The doping concentration of the second conductivity type doped well region 133 may be greater than or equal to about 1×10¹⁷ cm⁻³ and less than or equal to about 1×10¹⁹ cm⁻³. The material, doping type, doping concentration, etc. of the second conductivity type doped well region 133 are not limited thereto and may be changed in various ways.

The semiconductor device may further include a second conductivity type doped layer 135 and a first conductivity type doped layer 137 on the first conductivity type semiconductor layer 131.

The second conductivity type doped layer 135 may be disposed within the second conductivity type doped well region 133. The second conductivity type doped layer 135 may be disposed on the first conductivity type semiconductor layer 131 and may have an upper surface that is in direct contact with the lower surface of the silicide layer 190 connected to the source electrode 170 to be described later.

At least a portion of the upper surface of the second conductivity type doped layer 135 may be in contact with the lower surface of the silicide layer 190 described later, but is not limited thereto. For example, at least a portion of the upper surface of the second conductivity type doped layer 135 may be in contact with the lower surface of the source electrode 170. At this time, the second conductivity type doped layer 135 may have a width wider than the width of the source electrode 170.

The second conductivity type doped layer 135 may extend in the third direction D3 from the upper surface of the first conductivity type semiconductor layer 131. At this time, the thickness of the second conductivity type doped layer 135 along the third direction D3 may be smaller than the thickness of the second conductivity type doped well region 133 along the third direction D3. Additionally, the second conductivity type doped layer 135 may have a narrower width than the second conductivity type doped well region 133. That is, the second conductivity type doped layer 135 may be buried within the second conductivity type doped well region 133. The second conductivity type doped layer 135 may be formed in at least a portion of the second conductivity type doped well region 133 through ion implantation.

The second conductivity type doped layer 135 may include SiC. For example, the second conductivity type doped layer 135 may include 4H SiC. The second conductivity type doped layer 135 may be doped with p type. The second conductivity type doped layer 135 may form an ohmic contact with the source electrode 170. For this purpose, the second conductivity type doped layer 135 may be doped at a high concentration as a p type. In some implementations, the doping concentration of the second conductivity type doped layer 135 may be higher than the doping concentration of the second conductivity type doped well region 133. The doping concentration of the second conductivity type doped layer 135 may be greater than or equal to about 1×10¹⁸ cm⁻³ and less than or equal to about 5×10²⁰ cm⁻³. The material, doping type, doping concentration, etc. of the second conductivity type doped layer 135 are not limited thereto and may be changed in various ways.

The first conductivity type doped layer 137 may be disposed within the second conductivity type doped well region 133. The first conductivity type doped layer 137 may be disposed on the first conductivity type semiconductor layer 131 and may surround both sides of the second conductivity type doped layer 135. The upper surface of the first conductivity type doped layer 137 may be overlapped with at least a portion of the gate electrode 150 and at least a portion of the gate insulation layer 151 in the third direction D3, which will be described later. In addition, the upper surface of the first conductivity type doped layer 137 may be overlapped with at least a portion of the source electrode 170 described later in the third direction D3, but is not limited thereto. The upper surface of the first conductivity type doped layer 137 may directly contact the gate insulation layer 151 to be described later.

The first conductivity type doped layer 137 may extend in the third direction D3 from the upper surface of the first conductivity type semiconductor layer 131. The first conductivity type doped layer 137 may be buried within the second conductivity type doped well region 133. At this time, the thickness of the first conductivity type doped layer 137 along the third direction D3 may be smaller than the thickness of the second conductivity type doped well region 133 along the third direction D3.

The first conductivity type doped layer 137 may be a doped region formed using an ion implantation process within the first conductivity type semiconductor layer 131. The first conductivity type doped layer 137 may include SiC. For example, the first conductivity type doped layer 137 may include 4H SiC. The first conductivity type doped layer 137 may be doped with n type. The first conductivity type doped layer 137 may be doped as an n type at a high concentration. The first conductivity type doped layer 137 may be doped with a higher doping concentration than the first conductivity type semiconductor layer 131. The doping concentration of the first conductivity type doped layer 137 may be greater than or equal to about 1×10¹⁸ cm⁻³ and less than or equal to about 5×10²⁰ cm⁻³. The material, doping type, doping concentration, etc. of the first conductivity type doped layer 137 are not limited thereto and may be changed in various ways.

The gate electrode 150 may be disposed on the first conductivity type semiconductor layer 131. The gate electrode 150 may be spaced apart from the first conductivity type semiconductor layer 131. For example, the gate electrode 150 may be spaced apart from the first conductivity type semiconductor layer 131 in a vertical direction (e.g., in the third direction D3) by a gate insulation layer 151. In some implementations, the semiconductor device may have a planar gate structure. That is, in the semiconductor device, the gate electrode 150 has a flat plate shape with an upper surface and a lower surface, and the lower surface of the gate electrode 150 may be disposed at a higher level than the uppermost surface of the first conductivity type semiconductor layer 131. However, this is not limited to the above, and the semiconductor device according to some implementations may have a trench-shaped gate structure. For example, in a semiconductor device, a trench of a predetermined depth is formed in a first conductivity type semiconductor layer 131, and a gate electrode 150 may be disposed inside the trench spaced apart from the first conductivity type semiconductor layer 131 in a third direction D3. Additionally, the gate electrode 150 may be disposed spaced apart from the first conductivity type semiconductor layer 131 in the first direction D1 and/or the second direction D2. The gate electrode 150 may be overlapped with the second conductivity type doped well region 133 and the first conductivity type doped layer 137 in the third direction D3.

The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide, a conductive metal oxynitride, or a combination thereof. The gate electrode 150 may be made of a single layer or multiple layers.

The gate insulation layer 151 may be disposed between the first conductivity type semiconductor layer 131 and the gate electrode 150. That is, the gate insulation layer 151 may be disposed under the third direction D3 of the gate electrode 150 and may cover the lower surface of the gate electrode 150. The gate electrode 150 may be insulated from the first conductivity type semiconductor layer 131 by a gate insulation layer 151. The thickness of the gate insulation layer 151 may be substantially constant.

The gate insulation layer 151 may be overlapped with the second conductivity type doped well region 133 and the first conductivity type doped layer 137 in the third direction D3. The lower surface of the gate insulation layer 151 may be in direct contact with the second conductivity type doped well region 133 and the first conductivity type doped layer 137, but is not limited thereto.

The gate insulation layer 151 may include an insulating material. For example, the gate insulation layer 151 may include SiO₂. However, it is not limited to this, and the material of the gate insulation layer 151 may be changed in various ways. As another example, the gate insulation layer 151 may include SiN, SiON, SiC, SiCN, or a combination thereof. The gate insulation layer 151 may be formed of a single layer or multiple layers.

The first interlayer insulation layer 140 may be disposed on the first conductivity type semiconductor layer 131. For example, the first interlayer insulation layer 140 may be disposed on the gate electrode 150. In other words, the first interlayer insulation layer 140 may cover the upper surface and side surface of the gate electrode 150. The first interlayer insulation layer 140 may cover the side surface of the gate insulation layer 151. The first interlayer insulation layer 140 may also be disposed on the first conductivity type doped layer 137. The first interlayer insulation layer 140 may have a lower surface that is in contact with at least a portion of the upper surface of the first conductivity type doped layer 137. The gate electrode 150 may be insulated from the source electrode 170 by the first interlayer insulation layer 140.

The first interlayer insulation layer 140 may include an insulating material. For example, the first interlayer insulation layer 140 may include the same insulating material as the gate insulation layer 151. For example, the first interlayer insulation layer 140 may include SiO₂. However, it is not limited thereto, and the first interlayer insulation layer 140 may include various types of insulating materials to insulate the gate electrode 150 from the source electrode 170. For example, the first interlayer insulation layer 140 may include SiOP, SiN, SiON, or a combination thereof. The first interlayer insulation layer 140 may be formed of a single layer or multiple layers. When the first interlayer insulation layer 140 is made of the same material as the gate insulation layer 151, the boundary between the first interlayer insulation layer 140 and the gate insulation layer 151 may not be clearly distinguished at the portion where the first interlayer insulation layer 140 and the gate insulation layer 151 come into contact.

The source electrode 170 may be disposed on the second conductivity type doped well region 133. The second conductivity type doped layer 135 and the first conductivity type doped layer 137 may be disposed between the source electrode 170 and the second conductivity type doped well region 133. The source electrode 170 may be electrically connected to the second conductivity type doped well region 133 by the second conductivity type doped layer 135. Through the source electrode 170, current or voltage can be provided to the cell region CELL.

The source electrode 170 may include a first source electrode 171 and a second source electrode 172.

The first source electrode 171 may be disposed on the second conductivity type doped well region 133. The first source electrode 171 may be disposed on both sides of the gate electrode 150. However, it is not limited to this, and the first source electrode 171 may be disposed only on one side of the gate electrode 150. The first source electrode 171 may be disposed on the gate electrode 150.

A first interlayer insulation layer 140 may be disposed between the first source electrode 171 and the gate electrode 150. The first source electrode 171 may be separated from the gate electrode 150 by the first interlayer insulation layer 140. The first source electrode 171 may be in contact with the side and upper surfaces of the first interlayer insulation layer 140.

For example, the first source electrode 171 may have a first portion 171P1 on the gate electrode 150 and a second portion 171P2 between the gate electrodes 150.

The first portion 171P1 of the first source electrode 171 may be disposed on the cell region CELL. The first portion 171P1 of the first source electrode 171 may cover the cell region CELL.

The first portion 171P1 of the first source electrode 171 may be a plane (hereinafter referred to as "plane") extending in the first direction D1 and the second direction D2 perpendicular to the third direction D3, for example, the area of the cell region CELL in FIG. 1 along the first direction D1 and the second direction D2 may be substantially the same. In other words, the first portion 171P1 of the first source electrode 171 may be completely overlapped with the cell region CELL in the third direction D3. In some implementations, the first portion 171P1 of the first source electrode 171 may have a larger area in the first direction D1 and the second direction D2 than the cell region CELL on a plane (e.g., FIG. 1). In other words, the first portion 171P1 of the first source electrode 171 may be only partially overlapped with the cell region CELL in the third direction D3, but the cell region CELL may be completely overlapped with the first portion 171P1 of the first source electrode 171 in the third direction D3.

The second portion 171P2 of the first source electrode 171 may be disposed on either side of the gate electrode 150 in the first direction D1 or the second direction D2. The second portion 171P2 of the first source electrode 171 may be surrounded by the gate electrodes 150 with the first interlayer insulation layer 140 interposed therebetween. However, it is not limited thereto, and the second portion 171P2 of the first source electrode 171 may be disposed only on one side of the gate electrode 150.

The second portion 171P2 of the first source electrode 171 may be a portion extending downward in the third direction D3 from the first portion 171P1 of the first source electrode 171 toward the second conductivity type doped well region 133. The second portion 171P2 of the first source electrode 171 may extend downward in the third direction D3 and make an active source contact with the second conductivity type doped well region 133. The second portion 171P2 of the first source electrode 171 may be overlapped with the second conductivity type doped layer 135 and the first conductivity type doped layer 137 in the third direction D3. However, it is not limited thereto, and the second portion 171P2 of the first source electrode 171 may not be overlapped with the first conductivity type doped layer 137 in the third direction D3. At this time, the upper surface of the first conductivity type doped layer 137 may be covered by a gate insulation layer 151.

For example, the first source electrode 171 may include a conductive material. For example, the first source electrode 171 may include a metal, a metal alloy, a conductive metal nitride, a metal silicide, a doped semiconductor material, a conductive metal oxide, or a conductive metal oxynitride. For example, the first source electrode 171 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbide nitride (TiAIC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The first source electrode 171 may be formed of a single layer or multiple layers.

The second source electrode 172 may be disposed on the first source electrode 171.

The second source electrode 172 is electrically connected to the first source electrode 171, and an externally supplied source voltage may be applied to the first source electrode 171 through the second source electrode 172.

The second source electrode 172 may be disposed on the cell region CELL. The second source electrode 172 may cover the cell region CELL.

For example, the second source electrode 172 may have substantially the same area as the cell region CELL in the first direction D1 and the second direction D2 on a plane (e.g., FIG. 1). In other words, the second source electrode 172 may be completely overlapped with the cell region CELL in the third direction D3. In some implementations, the second source electrode 172 may have a larger area in the first direction D1 and the second direction D2 than the cell region CELL on a plane (e.g., FIG. 1). In other words, the second source electrode 172 may be only partially overlapped with the cell region CELL in the third direction D3, but the cell region CELL may be completely overlapped with the second source electrode 172 in the third direction D3. Alternatively, the second source electrode 172 may have a smaller area in the first direction D1 and the second direction D2 than the cell region CELL on a plane (e.g., FIG. 1). In other words, the second source electrode 172 may be completely overlapped with the cell region CELL in the third direction D3, but the cell region CELL may be only partially overlapped with the second source electrode 172 in the third direction D3.

Additionally, the second source electrode 172 may have substantially the same area as the first portion 171P1 of the first source electrode 171 in the first direction D1 and the second direction D2 on a plane (e.g., FIG. 1). In other words, the second source electrode 172 may be completely overlapped with the first portion 171P1 of the first source electrode 171 in the third direction D3. In some implementations, the second source electrode 172 may have a larger area in the first direction D1 and the second direction D2 than the first portion 171P1 of the first source electrode 171 on a plane (e.g., FIG. 1). In other words, the second source electrode 172 may be only partially overlapped with the first portion 171P1 of the first source electrode 171 in the third direction D3, but the first portion 171P1 of the first source electrode 171 may be completely overlapped with the second source electrode 172 in the third direction D3. Alternatively, the second source electrode 172 may have a smaller area in the first direction D1 and the second direction D2 than the first portion 171P1 of the first source electrode 171 on a plane (e.g., FIG. 1). In other words, the second source electrode 172 may be completely overlapped with the first portion 171P1 of the first source electrode 171 in the third direction D3, but the first portion 171P1 of the first source electrode 171 may be only partially overlapped with the second source electrode 172 in the third direction D3.

For example, the second source electrode 172 may include a conductive material. For example, the second source electrode 172 may include a metal, a metal alloy, a conductive metal nitride, a metal silicide, a doped semiconductor material, a conductive metal oxide, or a conductive metal oxynitride. For example, the second source electrode 172 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbide nitride (TiAIC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The second source electrode 172 may be formed of a single layer or multiple layers.

For example, the thickness of the second source electrode 172 may be greater than or equal to about 10 nm, for example, greater than or equal to about 20 nm, greater than or equal to about 30 nm, greater than or equal to about 40 nm, greater than or equal to about 50 nm, greater than or equal to about 60 nm, greater than or equal to about 70 nm, greater than or equal to about 80 nm, greater than or equal to about 90 nm, greater than or equal to about 100 nm, greater than or equal to about 200 nm, greater than or equal to about 300 nm, greater than or equal to about 400 nm, greater than or equal to about 500 nm, greater than or equal to about 600 nm, greater than or equal to about 700 nm, greater than or equal to about 800 nm, greater than or equal to about 900 nm, greater than or equal to about 1 µm, greater than or equal to about 2 µm, greater than or equal to about 3 µm, greater than or equal to about 4 µm, greater than or equal to about 5 µm, greater than or equal to about 6 µm, greater than or equal to about 7 µm, greater than or equal to about 8 µm, or greater than or equal to about 9 µm, and less than or equal to about 10 µm, for example, less than or equal to about 9 µm, less than or equal to about 8 µm, less than or equal to about 7 µm, less than or equal to about 6 µm, less than or equal to about 5 µm, less than or equal to about 4 µm, less than or equal to about 3 µm, less than or equal to about 2 µm, less than or equal to about 1 µm, less than or equal to about 900 nm, less than or equal to about 800 nm, less than or equal to about 700 nm, less than or equal to about 600 nm, less than or equal to about 500 nm, less than or equal to about 400 nm, less than or equal to about 300 nm, less than or equal to about 200 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 20 nm, and may be about 10 nm to about 10 µm. Here, the thickness of the second source electrode 172 may be the shortest distance along the third direction D3 from the lower surface to the upper surface of the second source electrode 172 in a cross-section (e.g., FIG. 2) cut in the first direction D1 and the third direction D3 perpendicular to the second direction D2.

The source electrode 170 may further include an interlayer source electrode 175 between the first source electrode 171 and the second source electrode 172. For example, a first source electrode 171, an interlayer source electrode 175, and a second source electrode 172 may be sequentially stacked in the third direction D3.

The first source electrode 171 may be electrically connected to the second source electrode 172 through the interlayer source electrode 175. In other words, the first source electrode 171 and the second source electrode 172 do not directly contact each other and may be spaced apart from each other in the third direction D3 with the interlayer source electrode 175 therebetween.

The interlayer source electrode 175 may be disposed on the cell region CELL. The interlayer source electrode 175 may cover the cell region CELL.

For example, the interlayer source electrode 175 may have substantially the same area in the first direction D1 and the second direction D2 as the cell region CELL, the first portion 171P1 of the first source electrode 171, and/or the second source electrode 172 on a plane (e.g., FIG. 1). In other words, the interlayer source electrode 175 may be completely overlapped with the cell region CELL, the first portion 171P1 of the first source electrode 171, and/or the second source electrode 172 in the third direction D3. In some implementations, the interlayer source electrode 175 may have a larger area in the first direction D1 and the second direction D2 than the cell region CELL, the first portion 171P1 of the first source electrode 171, and/or the second source electrode 172 on a plane (e.g., FIG. 1). In other words, the interlayer source electrode 175 may be only partially overlapped with the cell region CELL, the first portion 171P1 of the first source electrode 171, and/or the second source electrode 172 in the third direction D3, but the cell region CELL, the first portion 171P1 of the first source electrode 171, and/or the second source electrode 172 may be completely overlapped with the interlayer source electrode 175 in the third direction D3. Alternatively, the area along the first direction D1 and the second direction D2 may be smaller than that of the cell region CELL, the first portion 171P1 of the first source electrode 171, and/or the second source electrode 172 on the plane view (e.g., FIG. 1) of the interlayer source electrode 175. In other words, the interlayer source electrode 175 may be completely overlapped with the cell region CELL, the first portion 171P1 of the first source electrode 171, and/or the second source electrode 172 in the third direction D3, but the cell region CELL, the first portion 171P1 of the first source electrode 171, and/or the second source electrode 172 may be only partially overlapped with the interlayer source electrode 175 in the third direction D3.

For example, the thickness of the interlayer source electrode 175 may be greater than or equal to about 10 nm, for example greater than or equal to about 20 nm, greater than or equal to about 30 nm, greater than or equal to about 40 nm, greater than or equal to about 50 nm, greater than or equal to about 60 nm, greater than or equal to about 70 nm, greater than or equal to about 80 nm, greater than or equal to about 90 nm, greater than or equal to about 100 nm, greater than or equal to about 200 nm, greater than or equal to about 300 nm, greater than or equal to about 400 nm, greater than or equal to about 500 nm, greater than or equal to about 600 nm, greater than or equal to about 700 nm, greater than or equal to about 800 nm, greater than or equal to about 900 nm, greater than or equal to about 1 µm, greater than or equal to about 2 µm, greater than or equal to about 3 µm, greater than or equal to about 4 µm, greater than or equal to about 5 µm, greater than or equal to about 6 µm, greater than or equal to about 7 µm, greater than or equal to about 8 µm, or greater than or equal to about 9 µm, and less than or equal to about 10 µm, for example, less than or equal to about 9 µm, less than or equal to about 8 µm, less than or equal to about 7 µm, less than or equal to about 6 µm, less than or equal to about 5 µm, less than or equal to about 4 µm, less than or equal to about 3 µm, less than or equal to about 2 µm, less than or equal to about 1 µm, less than or equal to about 900 nm, less than or equal to about 800 nm, less than or equal to about 700 nm, less than or equal to about 600 nm, less than or equal to about 500 nm, less than or equal to about 400 nm, less than or equal to about 300 nm, less than or equal to about 200 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 20 nm, and may be about 10 nm to about 10 µm. Here, the thickness of the interlayer source electrode 175 may be the shortest distance along the third direction D3 from the lower surface to the upper surface of the second source electrode 172 in a cross-section (e.g., FIG. 2) cut in the first direction D1 and the third direction D3 perpendicular to the second direction D2.

The interlayer source electrode 175 may include insulation structures 1751 and conductive lines 1752.

The insulation structures 1751 may be disposed on the first source electrode 171. The insulation structures 1751 may be in contact with the upper surface of the first source electrode 171. Additionally, the insulation structures 1751 may be in contact with the side surfaces of the conductive lines 1752.

The insulation structures 1751 may be disposed spaced apart from each other in the first direction D1. Alternatively, the insulation structures 1751 may be disposed spaced apart from each other in the second direction D2. Alternatively, the insulation structures 1751 may be disposed spaced apart from each other in the first direction D1 and the second direction D2. For example, the insulation structures 1751 may be disposed in a matrix form along the first direction D1 and the second direction D2 on a plane (e.g., FIG. 1).

The insulation structures 1751 may be disposed densely. The insulation structures 1751 may be disposed with a set interval from one end to the other in the first direction D1 and the second direction D2 of the cell region CELL on a plane (e.g., FIG. 1). In other words, on the plane (e.g., FIG. 1) of the interlayer source electrode 175, the same number of insulation structures 1751 may be disposed within the same area at any location (e.g. there may be a uniform density and/or spacing of insulation structures 1751). The length of the insulation structures 1751 along the first direction D1 or the second direction D2 may be greater than or substantially equal to the separation distance between the insulation structures 1751 along the first direction D1 or the second direction D2.

The insulation structures 1751 may be disposed at positions where they are overlapped with the gate electrodes 150 in the third direction D3, and all the gate electrodes 150 may be disposed so that they are overlapped with at least one insulation structure 1751 in the third direction D3. Alternatively, the insulation structures 1751 may be disposed at positions where they are overlapped with the second portions 171P2 of the first source electrode 171 in the third direction D3, and the second portions 171P2 of all the first source electrodes 171 may be disposed so that they are overlapped with at least one insulation structure 1751 in the third direction D3.

The insulation structures 1751 may be disposed between the first source electrode 171 and the second source electrode 172 in the third direction D3. For example, the first source electrode 171, insulation structures 1751 of the interlayer source electrode 175, and the second source electrode 172 can be sequentially stacked in the third direction D3. The first source electrode 171 and the second source electrode 172 do not directly contact each other, and may be spaced apart from each other in the third direction D3 by insulation structures 1751 of the interlayer source electrode 175, and may be electrically connected by conductive lines 1752 of the interlayer source electrode 175 as described below.

The insulation structures 1751 may have various shapes, such as circular, elliptical, or polygonal, on a plane (e.g., FIG. 1). For example, a polygon may be a rectangle, a square, a rhombus, or a hexagon. Alternatively, the insulation structures 1751 may have a line shape extending in a first direction D1 and spaced apart in a second direction D2 on a plane (e.g., FIG. 1), or a line shape extending in a second direction D2 and spaced apart in the first direction D1.

The insulation structures 1751 may include an insulating material. For example, the insulation structures 1751 may include SiO₂. However, they are not limited thereto, and the insulation structures 1751 may include various types of insulating materials for insulating the first source electrode 171 and the second source electrode 172. For example, the insulation structures 1751 may include SiOP, SiN, SiON, or a combination thereof. The insulation structures 1751 may be made of a single layer or multiple layers.

The conductive lines 1752 are disposed between insulation structures 1751.

The conductive lines 1752 may be disposed on the first source electrode 171. The conductive lines 1752 may cover (e.g. may contact) the upper surface of the first source electrode 171. Additionally, the conductive lines 1752 may cover the side surfaces of the insulation structures 1751.

The conductive lines 1752 may have first conductive lines 1752D1 and/or second conductive lines 1752D2. The first conductive lines 1752D1 may extend in the first direction D1 and be spaced apart in the second direction D2 with insulation structures 1751 interposed therebetween. The second conductive lines 1752D2 may extend in the second direction D2 and be spaced apart in the first direction D1 with insulation structures 1751 interposed therebetween.

The first conductive lines 1752D1 and the second conductive lines 1752D2 may intersect each other. For better understanding and ease of description, the conductive lines 1752 have been described as having first conductive lines 1752D1 and second conductive lines 1752D2, but the conductive lines 1752 are not limited to having a straight linear shape, and the first conductive lines 1752D1 and the second conductive lines 1752D2 may include the same material and be formed simultaneously in the same process, in which case the boundary is not clearly distinguished, and the first conductive lines 1752D1 and the second conductive lines 1752D2 may substantially have one configuration with only the extending direction being different. Accordingly, the first conductive lines 1752D1 and the second conductive lines 1752D2 may be connected to each other at the point where they intersect to surround the insulation structures 1751 between the first conductive lines 1752D1 and the second conductive lines 1752D2. In other words, the conductive lines 1752 electrically connect the first and second source electrodes 171 and 172 disposed on the upper and lower sides of the insulation structures 1751, and may be interlayer conductive layers disposed between the insulation structures 1751 in the first direction D1 or the second direction D2.

The first conductive lines 1752D1 may be disposed densely. The first conductive lines 1752D1 may be disposed with a set interval from one end to the other in the second direction D2 of the cell region CELL on a plane (e.g., FIG. 1). In other words, on a plane (e.g., FIG. 1), the same number of first conductive lines 1752D1 may be disposed within the same area at any location of the interlayer source electrode 175 (e.g. there may be a uniform density and/or spacing of first conductive lines 1752D1). Additionally, the second conductive lines 1752D2 may be disposed densely. The second conductive lines 1752D2 may be disposed with a set interval from one end to the other in the first direction D1 of the cell region CELL on a plane (e.g., FIG. 1). In other words, on a plane (e.g., FIG. 1), the same number of second conductive lines 1752D2 may be disposed within the same area at any location of the interlayer source electrode 175 (e.g. there may be a uniform density and/or spacing of second conductive lines 1752D2). The length of the first conductive lines 1752D1 along the second direction D2 may be greater than or substantially equal to the separation distance between the first conductive lines 1752D1 along the second direction D2. Additionally or alternatively, the length of the second conductive lines 1752D2 along the first direction D1 may be greater than or substantially equal to the separation distance between the second conductive lines 1752D2 along the first direction D1.

Here, the length of the first conductive line 1752D1 along the second direction D2 may be the shortest distance along the second direction D2 from a side surface located on one side of the first conductive line 1752D1 along the second direction D2 to a side surface located on the other side on a cross-section cut in the second direction D2 and the third direction D3 perpendicular to the first direction D1. In other words, the length of the first conductive line 1752D1 along the second direction D2 may be the shortest separation distance along the second direction D2 between the insulation structures 1751 located on both sides of the first conductive line 1752D1 along the second direction D2. In addition, the length of the second conductive line 1752D2 along the first direction D1 may be the shortest distance along the first direction D1 from a side surface located on one side of the second conductive line 1752D2 in the first direction D1 to a side surface located on the other side on a cross-section cut in the first direction D1 and the third direction D3 perpendicular to the second direction D2. In other words, the length of the second conductive line 1752D2 along the first direction D1 may be the shortest separation distance along the first direction D1 between the insulation structures 1751 located on both sides of the second conductive line 1752D2 along the first direction D1.

The first conductive lines 1752D1 may be disposed at positions where they are overlapped with the gate electrodes 150 in the third direction D3, and all the gate electrodes 150 may be disposed so as to be overlapped with at least one of the first conductive lines 1752D1 in the third direction D3. Alternatively, the first conductive lines 1752D1 may be disposed at positions where they are overlapped with the second portions 171P2 of the first source electrodes 171 in the third direction D3, and the second portions 171P2 of all the first source electrodes 171 may be disposed so as to be overlapped with at least one of the first conductive lines 1752D1 in the third direction D3.

The second conductive lines 1752D2 may be disposed at positions that are overlapped with the gate electrodes 150 in the third direction D3, and all of the gate electrodes 150 may be disposed to be overlapped with at least one of the second conductive lines 1752D2 in the third direction D3. Alternatively, the second conductive lines 1752D2 may be disposed at positions where they are overlapped with the second portions 171P2 of the first source electrodes 171 in the third direction D3, and the second portions 171P2 of all the first source electrodes 171 may be disposed so that they are overlapped with at least one of the second conductive lines 1752D2 in the third direction D3.

The conductive lines 1752 may be disposed between the first source electrode 171 and the second source electrode 172 in the third direction D3. For example, the first source electrode 171, the conductive lines 1752 of the interlayer source electrode 175, and the second source electrode 172 may be sequentially stacked in the third direction D3. The first source electrode 171 and the second source electrode 172 may not directly contact each other, and may be spaced apart from each other in the third direction D3 by insulation structures 1751 of the interlayer source electrode 175, and may be electrically connected by conductive lines 1752 of the interlayer source electrode 175.

For example, the conductive lines 1752 may include a conductive material. For example, the conductive lines 1752 may include the same conductive material as the first source electrode 171 and the second source electrode 172. In this case, the boundaries between the conductive lines 1752 and the first source electrode 171 and the second source electrode 172 may not be clearly distinguished.

For example, the conductive lines 1752 may include a metal, a metal alloy, a conductive metal nitride, a metal silicide, a doped semiconductor material, a conductive metal oxide, or a conductive metal oxynitride. For example, the conductive lines 1752 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbide (TiAIC-N), titanium aluminum carbide (TiAIC), titanium carbide (TiC), tantalum carbide (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The conductive lines 1752 may be formed of a single layer or multiple layers.

The center lines of the first conductive lines 1752D1 along the second direction D2 (e.g. extending along the first direction D1) may be overlapped with the second portions 171P2 of the first source electrode 171 along the third direction D3. Alternatively or in addition, the center lines of the second conductive lines 1752D2 along the first direction D1 (e.g. extending along the second direction D2) may be overlapped with the second portions 171P2 of the first source electrode 171 in the third direction D3.

The center lines of the first conductive lines 1752D1 along the second direction D2 may not be overlapped with the center lines of the gate electrodes 150 along the first direction D1 or the second direction D2 in the third direction D3. Alternatively or in addition, the center lines of the second conductive lines 1752D2 along the first direction D1 may not be overlapped with the center lines of the gate electrodes 150 along the first direction D1 or the second direction D2 in the third direction D3.

Since the insulation structures 1751 are disposed between the first conductive lines 1752D1 or between the second conductive lines 1752D2, the center points of the insulation structures 1751 along the first direction D1 and the second direction D2 may not be overlapped with the second portions 171P2 of the first source electrode 171 along the third direction D3. The center points of the insulation structures 1751 along the first direction D1 and the second direction D2 may be overlapped with the center lines of the gate electrodes 150 along the first direction D1 or the second direction D2 in the third direction D3.

Here, the center line along the second direction D2 of the first conductive line 1752D1 may be an imaginary line segment that passes through the center points of the second direction D2 of the first conductive line 1752D1 and extends in the first direction D1 along the first conductive line 1752D1. The center point of the second direction D2 of the first conductive line 1752D1 may be a point dividing the shortest distance between the two sides facing each away from other in the second direction D2 of the first conductive line 1752D1. The center line along the first direction D1 of the second conductive line 1752D2 may be an imaginary line segment that passes through the center points of the first direction D1 of the second conductive line 1752D2 and extends in the second direction D2 along the second conductive line 1752D2. The center point of the first direction D1 of the second conductive line 1752D2 may be a point dividing the shortest distance between the two side surfaces facing away from each other in the first direction D1 of the second conductive line 1752D2. The center point of the insulation structure 1751 along the first direction D1 and the second direction D2 may be the point where the diameter of the insulation structure 1751 along the first direction D1 and the diameter along the second direction D2 meet.

The center line of the gate electrode 150 along the first direction D1 or the second direction D2 may be an imaginary line segment that passes through the center points of the gate electrode 150 along the second direction D2 and extends along the gate electrode 150 in the first direction D1 when the gate electrode 150 extends in the first direction D1, in other words, when the length of the gate electrode 150 along the first direction D1 is greater than the length along the second direction D2. The center point of the second direction D2 of the gate electrode 150 may be a point dividing the shortest distance between the two side surfaces facing away from each other in the second direction D2 of the gate electrode 150. Alternatively, the center line of the gate electrode 150 along the first direction D1 or the second direction D2 may be an imaginary line segment that passes through the center points of the gate electrode 150 along the first direction D1 and extends along the gate electrode 150 in the second direction D2 when the gate electrode 150 extends in the second direction D2, in other words, when the length of the gate electrode 150 along the second direction D2 is greater than the length along the first direction D1. The center point of the first direction D1 of the gate electrode 150 may be a point dividing the shortest distance between the two side surfaces facing away from each other in the first direction D1 of the gate electrode 150. Alternatively, the center line of the gate electrode 150 along the first direction D1 or the second direction D2 may be a point where the diameter of the gate electrode 150 along the first direction D1 and the diameter along the second direction D2 meet, when the length of the gate electrode 150 along the first direction D1 and the length of the gate electrode 150 along the second direction D2 are substantially the same.

In SiC power semiconductor devices, there is a method of controlling the current to prevent a short-circuit, but in this case, the resistance of the channel, etc. increases, so the on-state drain-source resistance (Rdsₒₙ) increases. Accordingly, the channel length may be reduced to reduce Rdsₒₙ. However, changing the channel length requires an increase in current, which incurs a loss in saturation drain current (Idₛₐₜ). Therefore, it is necessary to prevent short-circuits while maintaining Rdsₒₙ while reducing Idₛₐₜ.

A semiconductor device according to some implementations includes a source electrode 170 including a first source electrode 171, a second source electrode 172, and an interlayer source electrode 175 including insulation structures 1751 and conductive lines 1752. In other words, the source electrode 170 includes an interlayer source electrode 175 that increases the electrical resistance and increases the length of the current flow path between the first source electrode 171 and the second source electrode 172.

According to this, as shown in the circuit diagram of FIG. 3, the gate pad 155 on the gate (G) side is in direct contact with the metal, but the current entering the source (S) side is supplied through the interlayer source electrode 175 with high electrical resistance. In this way, by increasing the local resistance in the current path on the source (S) side, a large amount of current flows due to the ballast resistance principle, and the potential difference between the gate (G) and the source (S) is reduced due to the voltage drop. When the potential difference between the gate G and source S decreases, the channel is closed, limiting the current and preventing a short-circuit.

Thus, the short-circuit may be prevented by reducing Idₛₐₜ without changing Rdsₒₙ and without changing the structure in the active source contact region, such as changing the channel length, without adding additional resistance outside the circuit (e.g., package or module).

In addition, since the source electrode 170 includes an interlayer source electrode 175 that increases the electrical resistance and increases the length of the current flow path between the first source electrode 171 and the second source electrode 172, the areas of the first source electrode 171 and the second source electrode 172 are relatively large compared to the area of the interlayer source electrode 175, so that the current concentration of the active source contact may be reduced, and voltage overshooting or non-uniformity of the source current by a cell region CELL location may be improved, thereby improving current spreading.

The semiconductor device may further include a silicide layer 190 disposed between the source electrode 170 and the second conductivity type doped layer 135 and between the source electrode 170 and the first conductivity type doped layer 137.

The silicide layer 190 may be conformally disposed along the interface between the source electrode 170 and the second conductivity type doped layer 135 and between the source electrode 170 and the first conductivity type doped layer 137. The lower surface of the silicide layer 190 may directly contact the second conductivity type doped layer 135 and the first conductivity type doped layer 137. The upper surface of the silicide layer 190 may be in direct contact with the source electrode 170. The silicide layer 190 may include a metal silicide material. For example, the silicide layer 190 may include tungsten silicide (WSi), titanium silicide (TiSi), cobalt silicide (CoSi), nickel silicide (NiSi), or a combination thereof.

In the manufacturing process of a semiconductor device, a silicidation process may be performed on the upper surface of a second conductivity type doped layer 135 and a first conductivity type doped layer 137 to form a silicide layer 190. However, it is not limited thereto, and after forming the source electrode 170, an annealing process may be performed subsequently to reduce the contact resistance between the second conductivity type doped layer 135 and the source electrode 170 and between the first conductivity type doped layer 137 and the source electrode 170. Accordingly, the silicide layer 190 may be formed along the interface between the source electrode 170 and the second conductivity type doped layer 135 and between the source electrode 170 and the first conductivity type doped layer 137.

The drain electrode 180 may be disposed under the second surface, i.e., the lower surface, of the substrate 110. The upper surface of the drain electrode 180 may be in contact with the lower surface of the substrate 110. The drain electrode 180 may be in ohmic contact with the substrate 110. The region in contact with the drain electrode 180 within the substrate 110 may be doped at a relatively high concentration compared to other regions. However, it is not limited thereto, and another layer may be additionally disposed between the drain electrode 180 and the substrate 110. For example, a silicide layer may be disposed between the drain electrode 180 and the substrate 110. The silicide layer may include a metal silicide material. The drain electrode 180 and the substrate 110 may be electrically smoothly connected by the metal silicide layer.

The drain electrode 180 may include a conductive material. For example, the drain electrode 180 may include a metal, a metal alloy, a conductive metal nitride, a metal silicide, a doped semiconductor material, a conductive metal oxide, or a conductive metal oxynitride. The drain electrode 180 may be made of the same material as the source electrode 170 or may be made of a different material.

For example, the drain electrode 180 may be formed of titanium (Ti), titanium nitride (TiN), titanium silicon nitride (TiSiN), titanium aluminum nitride (TiAIN), titanium carbide (TiC), titanium aluminum (TiAl), titanium aluminum carbonitride (TiAIC-N), titanium aluminum carbide (TiAIC), tantalum (Ta), tantalum carbide (TaC), tantalum nitride (TaN), tantalum carbonitride (TaCN), tantalum silicon nitride (TaSiN), tantalum titanium nitride (TaTiN), tantalum aluminum nitride (TaAIN), tungsten (W), tungsten nitride (WN), tungsten carbide (WC), aluminum (Al), copper (Cu), cobalt (Co), nickel (Ni), nickel vanadium (Ni-V), nickel platinum (Ni-Pt), vanadium (V), zinc (Zn), niobium (Nb), niobium nitride (NbN), niobium carbide (NbC), molybdenum (Mo), molybdenum nitride (MoN), molybdenum carbide (MoC), ruthenium (Ru), platinum (Pt), rhodium (Rh), palladium (Pd), iridium (Ir), osmium (Os), silver (Ag), gold (Au), or a combination thereof, but is not limited thereto. The drain electrode 180 may be formed of a single layer or multiple layers.

For example, the thickness of the drain electrode 180 may be greater than or equal to about 100 nm, for example 1 µm, greater than or equal to about 2 µm, greater than or equal to about 3 µm, greater than or equal to about 4 µm, greater than or equal to about 5 µm, greater than or equal to about 6 µm, greater than or equal to about 7 µm, greater than or equal to about 8 µm, or greater than or equal to about 9 µm, and less than or equal to about 10 µm, for example , less than or equal to about 9 µm, less than or equal to about 8 µm, less than or equal to about 7 µm, less than or equal to about 6 µm, less than or equal to about 5 µm, less than or equal to about 4 µm, less than or equal to about 3 µm, less than or equal to about 2 µm, or less than or equal to about 1 µm, and may be about 100 nm to about 10 µm or about 100 nm to about 3 µm.

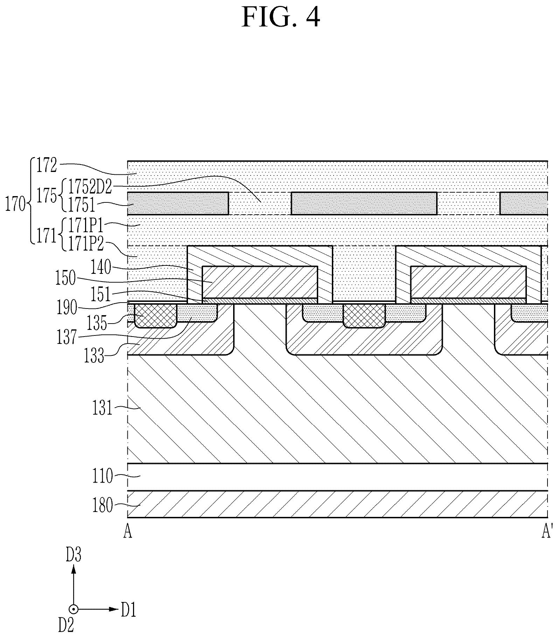

Hereinafter, semiconductor devices according to some implementations will be described with reference to FIGS. 4 and 34.

FIG. 4 is a cross-sectional view showing a semiconductor device according to some implementations, and is a drawing corresponding to FIG. 2.

The implementation illustrated in FIG. 4 is substantially the same as the implementation illustrated in FIG. 2, and thus a description thereof will be omitted and the differences will be mainly explained. Additionally, the same reference numerals are used for the same elements as in the previous implementation.

Referring to FIG. 4, the center lines of the first conductive lines 1752D1 along the second direction D2 may not be overlapped with the second portions 171P2 of the first source electrode 171 along the third direction D3. Alternatively or in addition, the center lines of the second conductive lines 1752D2 along the first direction D1 may not be overlapped with the second portions 171P2 of the first source electrode 171 along the third direction D3.

In this case, the center lines of the first conductive lines 1752D1 along the second direction D2 may be overlapped with the center lines of the gate electrodes 150 along the first direction D1 or the second direction D2 in the third direction D3. Alternatively or in addition, the center lines of the second conductive lines 1752D2 along the first direction D1 may be overlapped with the center lines of the gate electrodes 150 along the first direction D1 or the second direction D2 in the third direction D3.

Since the insulation structures 1751 are disposed between the first conductive lines 1752D1 or between the second conductive lines 1752D2, the center points of the insulation structures 1751 along the first direction D1 and the second direction D2 may be overlapped with the second portions 171P2 of the first source electrode 171 along the third direction D3. The center points of the insulation structures 1751 along the first direction D1 and the second direction D2 may not be overlapped with the center lines of the gate electrodes 150 along the first direction D1 or the second direction D2 in the third direction D3.

Accordingly, the length of the current path between the first source electrode 171 and the second source electrode 172 is further increased, thereby reducing the saturated drain current (Idₛₐₜ) without changing the drain/source on-resistance (Rdsₒₙ), thereby preventing a short-circuit.

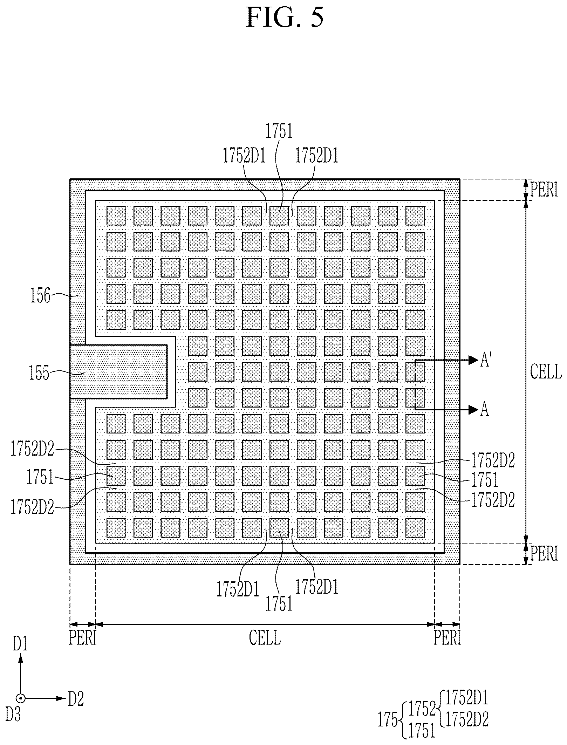

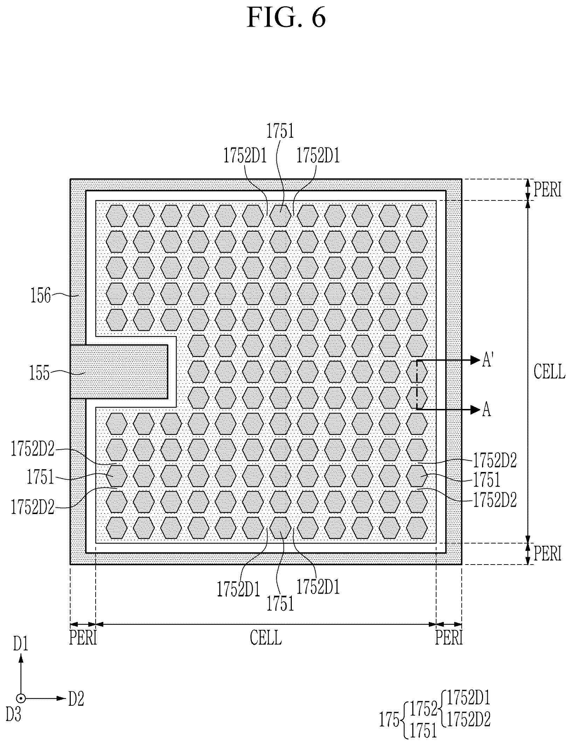

FIG. 5 is a plan view showing a semiconductor device according to some implementations. FIG. 6 is a plan view showing a semiconductor device according to some implementations.

The implementations illustrated in FIGS. 5 and 6 are substantially the same as the implementations illustrated in FIG. 1, and thus descriptions thereof will be omitted and the differences will be mainly explained. Additionally, the same reference numerals are used for the same elements as in the previous implementation.

In FIG. 1, it is illustrated that insulation structures 1751 have a circular shape on a plane extending in the first direction D1 and the second direction D2 perpendicular to the third direction D3.

In FIG. 5, it is illustrated that the insulation structures 1751 have a square shape on a plane extending in the first direction D1 and the second direction D2 perpendicular to the third direction D3.

In FIG. 6, it is illustrated that the insulation structures 1751 have a hexagonal shape on a plane extending in the first direction D1 and the second direction D2 perpendicular to the third direction D3.

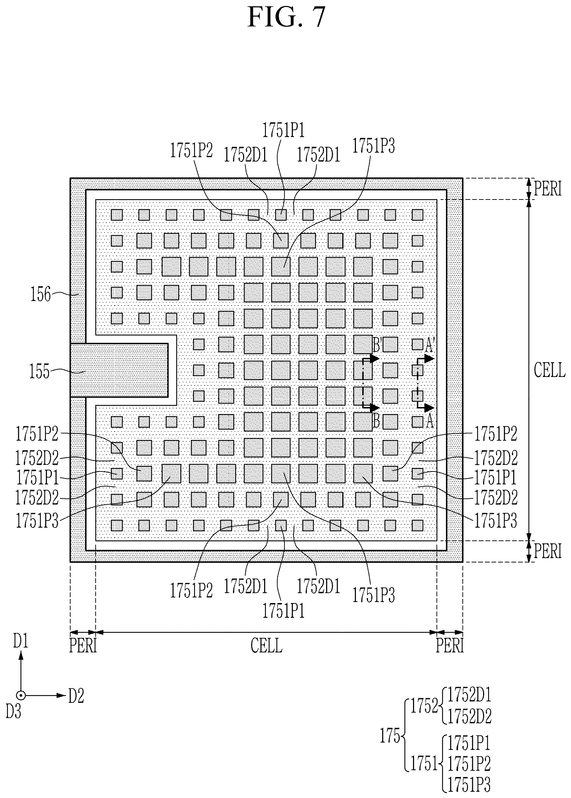

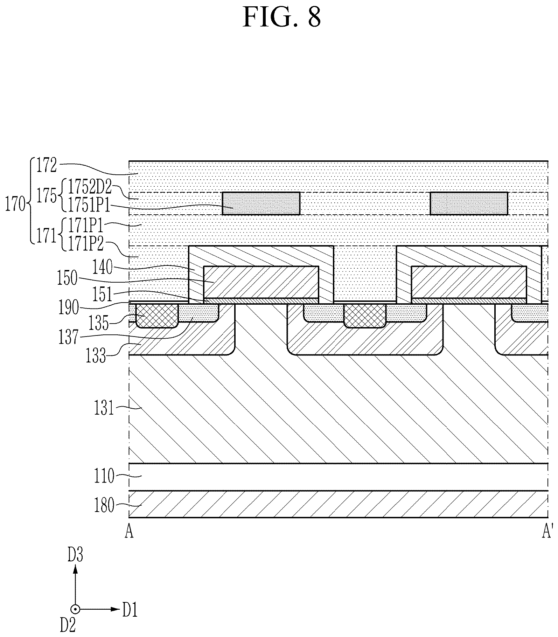

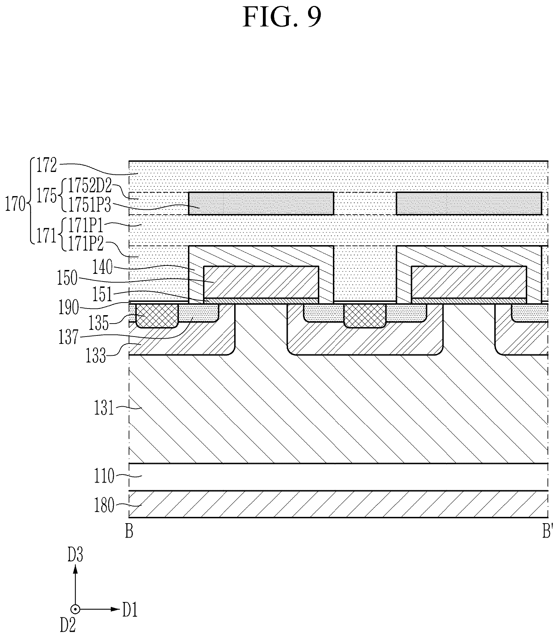

FIG. 7 is a plan view showing a semiconductor device according to some implementations. FIG. 8 is a cross-sectional view taken along line A-A' of FIG. 7. FIG. 9 is a cross-sectional view taken along line B-B' of FIG. 7.

The implementations illustrated in FIGS. 7 to 9 are substantially the same as the implementations illustrated in FIGS. 1 and 2, and thus descriptions thereof will be omitted and the differences will be mainly described. Additionally, the same reference numerals are used for the same elements as in the previous implementation.

For a clear understanding and simple illustration, FIG. 7 mainly illustrates the first conductive lines 1752D1, the second conductive lines 1752D2 of the conductive lines 1752 of the interlayer source electrodes 175, the first insulation structure 1751P1, the second insulation structure 1751P2, and the third insulation structure 1751P3 of the insulation structures 1751, the gate pad 155, and the gate wire 156, and the illustrations of the substrate 110, the first conductivity type semiconductor layer 131, the second conductivity type doped well region 133, the gate electrode 150, the gate insulation layer 151, the first source electrode 171 and the second source electrode 172 of the source electrode 170, and the drain electrode 180 are omitted.

Referring to FIGS. 7 to 9, the insulation structures 1751 of the interlayer source electrodes 175 may include first insulation structures 1751P1 and second insulation structures 1751P2. Additionally, the insulation structures 1751 of the interlayer source electrode 175 may further include third insulation structures 1751P3.

On a plane (hereinafter referred to as "plane") extending in the first direction D1 and the second direction D2 perpendicular to the third direction D3, for example, in FIG. 7, the first insulation structures 1751P1 may be disposed closer to the peripheral region PERI in the first direction D1 and the second direction D2 than the second insulation structures 1751P2. Additionally, the third insulation structures 1751P3 may be disposed further away from the peripheral region PERI in the first direction D1 and the second direction D2 than the first insulation structures 1751P1 and the second insulation structures 1751P2.

In other words, the first insulation structures 1751P1 may be disposed on the outer edge of the cell region CELL. The first insulation structures 1751P1 may be disposed adjacent to the gate pad 155 or gate wire 156 of the peripheral region PERI. The second insulation structures 1751P2 may be disposed in the central portion of the cell region CELL. The second insulation structures 1751P2 may be surrounded by the first insulation structures 1751P1. The first insulation structures 1751P1 may be disposed between the second insulation structures 1751P2 and the gate pad 155 or gate wire 156. Additionally, the third insulation structures 1751P3 may be disposed in the central portion of the cell region CELL. The third insulation structures 1751P3 may be surrounded by the first insulation structures 1751P1 and the second insulation structures 1751P2. First insulation structures 1751P1 and second insulation structures 1751P2 may be disposed between the third insulation structures 1751P3 and the gate pad 155 or gate wire 156.

For example, on a plane (e.g., FIG. 7), the first insulation structures 1751P1, the second insulation structures 1751P2, and the third insulation structures 1751P3 may be sequentially disposed from the peripheral region PERI in the first direction D1 and the second direction D2 or from the outer edge to the central portion of the cell region CELL in the first direction D1 and the second direction D2. In some implementations, the insulation structures 1751 of the interlayer source electrode 175 may further include fourth insulation structures, fifth insulation structures, sixth insulation structures, seventh insulation structures, eighth insulation structures, ninth insulation structures, or tenth insulation structures, and the fourth insulation structures, fifth insulation structures, sixth insulation structures, seventh insulation structures, eighth insulation structures, ninth insulation structures, or tenth insulation structures may be sequentially disposed as they move away from the peripheral region PERI.

For example, on a plane (e.g., FIG. 7), an area of (e.g. each of) the first insulation structures 1751P1 along the first direction D1 and the second direction D2 may be smaller than an area of (e.g. each of) the second insulation structures 1751P2 along the first direction D1 and the second direction D2. Additionally, an area of (e.g. each of) the second insulation structures 1751P2 along the first direction D1 and the second direction D2 may be smaller than an area of (e.g. each of) the third insulation structures 1751P3 along the first direction D1 and the second direction D2. In other words, an area of (e.g. each of) the insulation structures 1751 along the first direction D1 and the second direction D2 may increase as they move away from the peripheral region PERI in the first direction D1 and the second direction D2 or as they move from the outer edge to the central portion of the cell region CELL in the first direction D1 and the second direction D2.

Accordingly, the electrical resistance may be decreased near the gate pad 155 or gate wire 156 where the electric field is concentrated, thereby further improving the non-uniformity of the source current by a cell region CELL location.

In some implementations, when the insulation structures 1751 of the interlayer source electrode 175 further include fourth insulation structures, fifth insulation structures, sixth insulation structures, seventh insulation structures, eighth insulation structures, ninth insulation structures, or tenth insulation structures, an area of the third insulation structures 1751P3 along the first direction D1 and the second direction D2 may be smaller than an area of the fourth insulation structures along the first direction D1 and the second direction D2, an area of the fourth insulation structures along the first direction D1 and the second direction D2 may be smaller than an area of the fifth insulation structures along the first direction D1 and the second direction D2, an area of the fifth insulation structures along the first direction D1 and the second direction D2 may be smaller than an area of the sixth insulation structures along the first direction D1 and the second direction D2, an area of the sixth insulation structures along the first direction D1 and the second direction D2 may be smaller than an area of the seventh insulation structures along the first direction D1 and the second direction D2, an area of the seventh insulation structures along the first direction D1 and the second direction D2 may be smaller than an area of the eighth insulation structures along the first direction D1 and the second direction D2, an area of the eighth insulation structures along the first direction D1 and the second direction D2 may be smaller than an area of the ninth insulation structures along the first direction D1 and the second direction D2, and an area of the ninth insulation structures along the first direction D1 and the second direction D2 may be smaller than an area of the tenth insulation structures along the first direction D1 and the second direction D2.

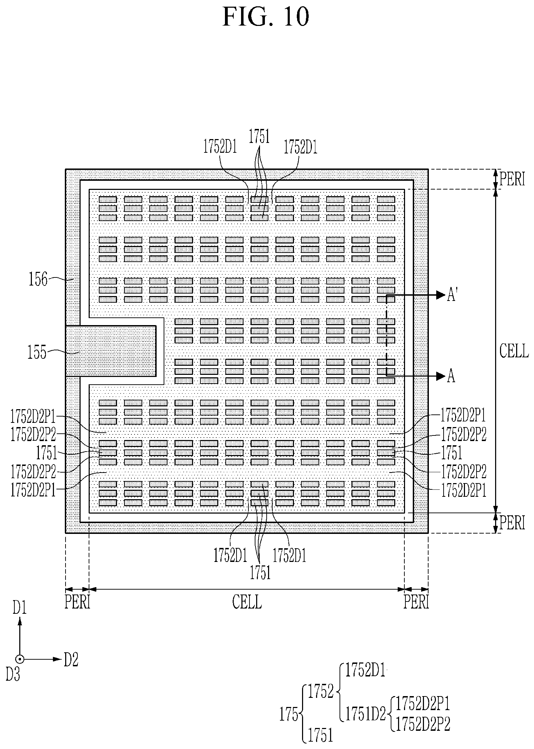

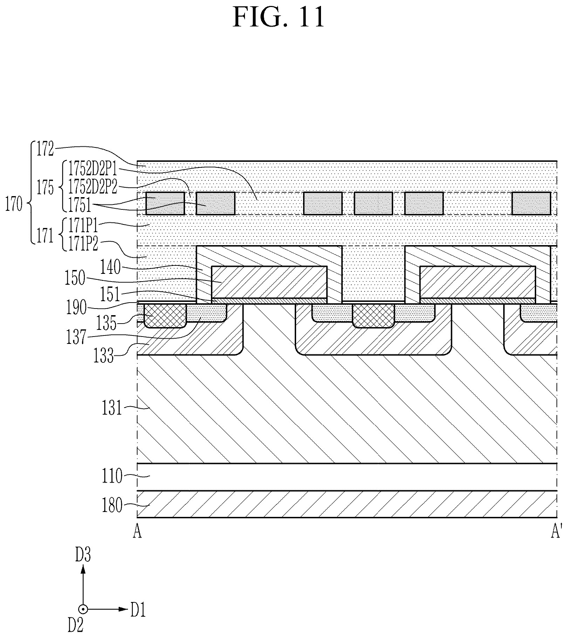

FIG. 10 is a plan view showing a semiconductor device according to some implementations. FIG. 11 is a cross-sectional view taken along line A-A' of FIG. 10.

The implementations illustrated in FIGS. 10 and 11 are substantially the same as the implementations illustrated in FIGS. 1 and 2, and thus descriptions thereof will be omitted and the differences will be mainly described. Additionally, the same reference numerals are used for the same elements as in the previous implementation.

For a clear understanding and a simple illustration, FIG. 10 mainly illustrates the first conductive overlapping lines and the first conductive non-overlapping lines of the first conductive lines 1752D1 of the conductive lines 1752 of the interlayer source electrodes 175, the second conductive overlapping lines 1752D2P1 and the second conductive non-overlapping lines 1752D2P2 of the second conductive lines 1752D2, the insulation structures 1751, the gate pad 155, and the gate wire 156, and the illustrations of the substrate 110, the first conductivity type semiconductor layer 131, the second conductivity type doped well region 133, the gate electrode 150, the gate insulation layer 151, the first source electrode 171 and the second source electrode 172 of the source electrode 170, and the drain electrode 180 are omitted.

Referring to FIGS. 10 and 11, the first conductive lines 1752D1 may include first conductive overlapping lines and first conductive non-overlapping lines 1752D1P2.

The center lines of the first conductive overlapping lines along the second direction D2 may be overlapped with the second portions 171P2 of the first source electrode 171 along the third direction D3. In this case, the center lines of the first conductive overlapping lines along the second direction D2 may not be overlapped with the center lines of the gate electrodes 150 along the first direction D1 or the second direction D2 in the third direction D3.

The center lines of the first conductive non-overlapping lines along the second direction D2 may not be overlapped with the second portions 171P2 of the first source electrode 171 along the third direction D3. In this case, the center lines of the first conductive non-overlapping lines along the second direction D2 may be overlapped with the center lines of the gate electrodes 150 along the first direction D1 or the second direction D2 in the third direction D3.

At this time, a length of the first conductive overlapping lines along the second direction D2 may be smaller than a length of the first conductive non-overlapping lines along the second direction D2. In other words, the closer the conductive lines 1752 are to the active source contact region, the smaller their width can be. Accordingly, the electrical resistance can be increased toward the active source contact region where the electric field is concentrated, thereby further improving non-uniformity of the source current by a cell region CELL location.

The second conductive lines 1752D2 may include second conductive overlapping lines 1752D2P2 and second conductive non-overlapping lines 1752D2P1.

The center lines of the second conductive overlapping lines 1752D2P2 along the first direction D1 may be overlapped with the second portions 171P2 of the first source electrode 171 in the third direction D3. In this case, the center lines of the second conductive overlapping lines 1752D2P2 along the first direction D1 may not be overlapped with the center lines of the gate electrodes 150 along the first direction D1 or the second direction D2 in the third direction D3.

The center lines of the second conductive non-overlapping lines 1752D2P1 along the first direction D1 may not be overlapped with the second portions 171P2 of the first source electrode 171 along the third direction D3. In this case, the center lines of the second conductive non-overlapping lines 1752D2P1 along the first direction D1 may be overlapped with the center lines of the gate electrodes 150 along the first direction D1 or the second direction D2 in the third direction D3.

At this time, the length of the second conductive overlapping lines 1752D2P2 along the first direction D1 may be smaller than the length of the second conductive non-overlapping lines 1752D2P1 along the first direction D1. In other words, the closer the conductive lines 1752 are to the active source contact region, the smaller their width may be. Accordingly, the electrical resistance can be increased toward the active source contact region where the electric field is concentrated, thereby further improving the non-uniformity of the source current by a cell region CELL location.

Meanwhile, in FIGS. 10 and 11, the lengths of the insulation structures 1751 along the first direction D1 or the second direction D2 are illustrated as being the same, but the present disclosure is not limited thereto, and the lengths of the insulation structures 1751 along the first direction D1 or the second direction D2 may be different from each other. For example, a length along the first direction D1 of the insulation structures 1751 that are overlapped with the second conductivity type doped layer 135 in the third direction D3 may be greater than a length along the first direction D1 of the insulation structures 1751 that are not overlapped with the second conductivity type doped layer 135 in the third direction D3, and for example, are overlapped with the gate electrode 150 in the third direction D3. Alternatively, a length along the second direction D2 of insulation structures 1751 that are overlapped with the second conductivity type doped layer 135 in the third direction D3 may be greater than a length along the second direction D2 of insulation structures 1751 that are not overlapped with the second conductivity type doped layer 135 in the third direction D3, and for example, are overlapped with the gate electrode 150 in the third direction D3.

In addition, in FIG. 10, the insulation structures 1751 are illustrated as being disposed in pairs of three adjacent ones in the first direction D1 and these pairs are spaced apart in the first direction D1, but the present disclosure is not limited thereto, and the insulation structures 1751 may be disposed in pairs of three adjacent ones in the second direction D2 and these pairs may be spaced apart in the second direction D2. Additionally, the insulation structures 1751 may be paired in any numbers (e.g. numbers of two, four, five, six, seven, eight, nine, or ten).

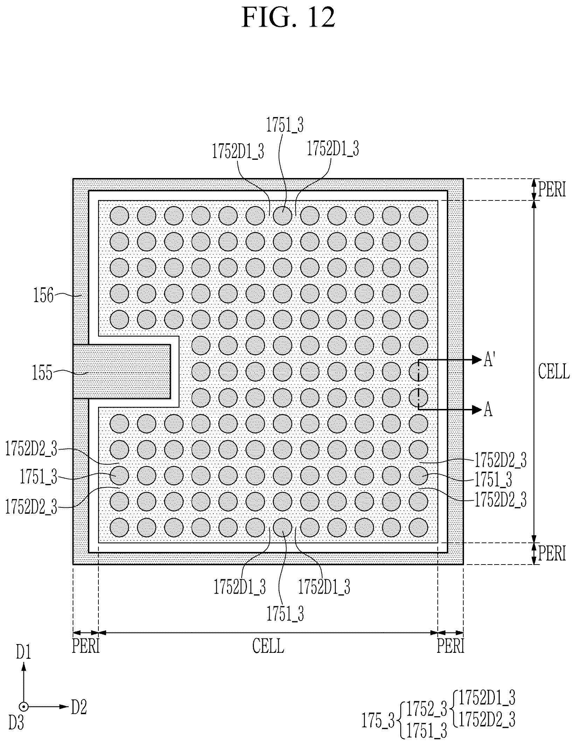

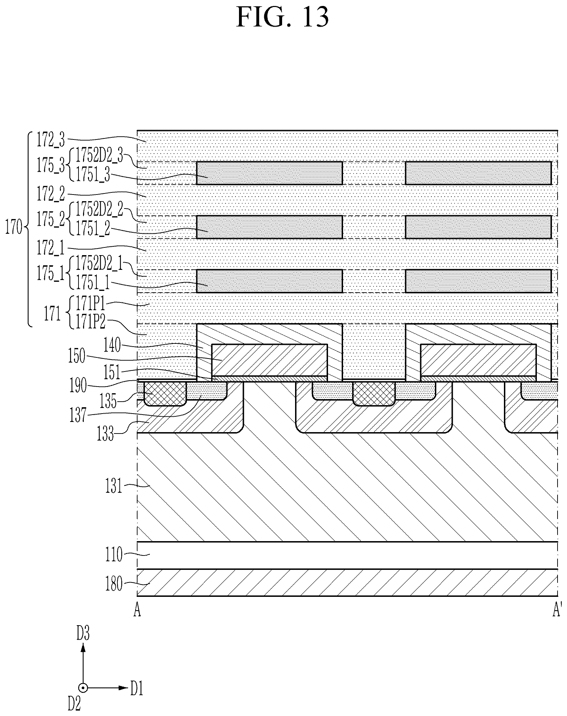

FIG. 12 is a plan view showing a semiconductor device according to some implementations. FIG. 13 is a cross-sectional view taken along line A-A' of FIG. 12.

The implementations illustrated in FIGS. 12 and 13 are substantially the same as the implementations illustrated in FIGS. 1 and 2, and thus descriptions thereof will be omitted and the differences will be mainly described. Additionally, the same reference numerals are used for the same elements as in the previous implementation.

For a clear understanding and simple illustration, FIG. 12 mainly illustrates the 3rd first conductive lines 1752D1_3 and the 3rd second conductive lines 1752D2_3 of the 3rd conductive lines 1752_3 of the 3rd interlayer source electrode 175_3, the 3rd insulation structures 1751_3 of the 3rd interlayer source electrode 175_3, the gate pad 155, and the gate wire 156, and the illustrations of the substrate 110, the first conductivity type semiconductor layer 131, the second conductivity type doped well region 133, the gate electrode 150, the gate insulation layer 151, the first source electrode 171 of the source electrode 170, the 1st interlayer source electrode 175_1, the 1st second source electrode 172_1, the 2nd interlayer source electrode 175_2, the 2nd second source electrode 172_2, and the 3rd second source electrode 172_3, and the drain electrode 180 are omitted.

Referring to FIGS. 12 and 13, the source electrode 170 may include multiple layers of second source electrodes 172_1, 172_2, and 172_3 and multiple layers of interlayer source electrodes 175_1, 175_2, and 175_3. The second source electrodes 172_1, 172_2, and 172_3 of multiple layers and the interlayer source electrodes 175_1, 175_2, and 175_3 of multiple layers may be alternately stacked in the third direction D3.

As an example, FIG. 13 illustrates that the source electrode 170 includes three layers of second source electrodes 172_1, 172_2, and 172_3 and three layers of interlayer source electrodes 175_1, 175_2, and 175_3. In other words, the source electrode 170 may include a 1st interlayer source electrode 175_1 (otherwise known as a first interlayer source electrode) on the first source electrode 171, a 1st second source electrode 172_1 (otherwise known as a first second source electrode) on the 1st interlayer source electrode 175_1, a 2nd interlayer source electrode 175_2 (otherwise known as a second interlayer source electrode) on the 1st second source electrode 172_1, a 2nd second source electrode 172_2 (otherwise known as a second second source electrode) on the 2nd interlayer source electrode 175_2, a 3rd interlayer source electrode 175_3 (otherwise known as a third interlayer source electrode) on the 2nd second source electrode 172_2, and a 3rd second source electrode 172_3 (otherwise known as a third second source electrode) on the 3rd interlayer source electrode 175_3.

In this way, when the source electrode 170 includes multiple layers of second source electrodes 172_1, 172_2, and 172_3 and multiple layers of interlayer source electrodes 175_1, 175_2, and 175_3, a length of the current path may be further increased to reduce a saturated drain current (Idₛₐₜ) without changing a drain/source on-resistance (Rdsₒₙ), thereby preventing a short-circuit.

In some implementations, the source electrode 170 may include the second source electrode 172 in 2 or more layers, for example, 3 or more layers, 4 or more layers, 5 or more layers, 6 or more layers, 7 or more layers, 8 or more layers, 9 or more layers, 10 or more layers, 20 or more layers, 30 or more layers, 40 or more layers, 50 or more layers, 60 or more layers, 70 or more layers, 80 or more layers, or 90 or more layers, and 100 or less layers, for example 90 or less layers, 80 or less layers, 70 or less layers, 60 or less layers, 50 or less layers, 40 or less layers, 30 or less layers, 20 or less layers, 10 or less layers, 9 or less layers, 8 or less layers, 7 or less layers, 6 or less layers, 5 or less layers, 4 or less layers, 3 or less layers, or 2 or less layers, and 2 to 100 layers. However, if the number of layers of the second source electrode 172 is too large, cracks or stress may occur in the interlayer source electrodes 175_1, 175_2, and 175_3 during scribing.

In addition, the source electrode 170 may include interlayer source electrodes 175_1, 175_2, and 175_3 in 2 or more layers, for example, 3 or more layers, 4 or more layers, 5 or more layers, 6 or more layers, 7 or more layers, 8 or more layers, 9 or more layers, 10 or more layers, 20 or more layers, 30 or more layers, 40 or more layers, 50 or more layers, 60 or more layers, 70 or more layers, 80 or more layers, or 90 or more layers, and 100 or less layers, for example 90 or less layers, 80 or less layers, 70 or less layers, 60 or less layers, 50 or less layers, 40 or less layers, 30 or less layers, 20 or less layers, 10 or less layers, 9 or less layers, 8 or less layers, 7 or less layers, 6 or less layers, 5 or less layers, 4 or less layers, 3 or less layers, or 2 or less layers, and 2 to 100 layers. However, if the number of layers of the interlayer source electrodes 175_1, 175_2, and 175_3 is too large, cracks or stress may occur in the interlayer source electrodes 175_1, 175_2, and 175_3 during scribing. The number of interlayer source electrodes may be equal to the number of second source electrodes 172.

The multiple layers of interlayer source electrodes 175_1, 175_2, and 175_3 each include insulation structures 1751_1, 1751_2, and 1751_3 and conductive lines (e.g., 1752_3). The conductive lines (e.g., 1752_3) may have first conductive lines (e.g., 1752D1_3) and second conductive lines 1752D2_1, 1752D2_2, and 1752D2_3.

For example, the 1st interlayer source electrode 175_1 may include 1st insulation structures 1751_1, 1st first conductive lines (not shown), and 1st second conductive lines 1752D2_1. The 2nd interlayer source electrode 175_2 may include 2nd insulation structures 1751_2, 2nd first conductive lines (not shown), and 2nd second conductive lines 1752D2_2. The 3rd interlayer source electrode 175_3 may include 3rd insulation structures 1751_3, 3rd first conductive lines 1752D1_3, and 3rd second conductive lines 1752D2_3.

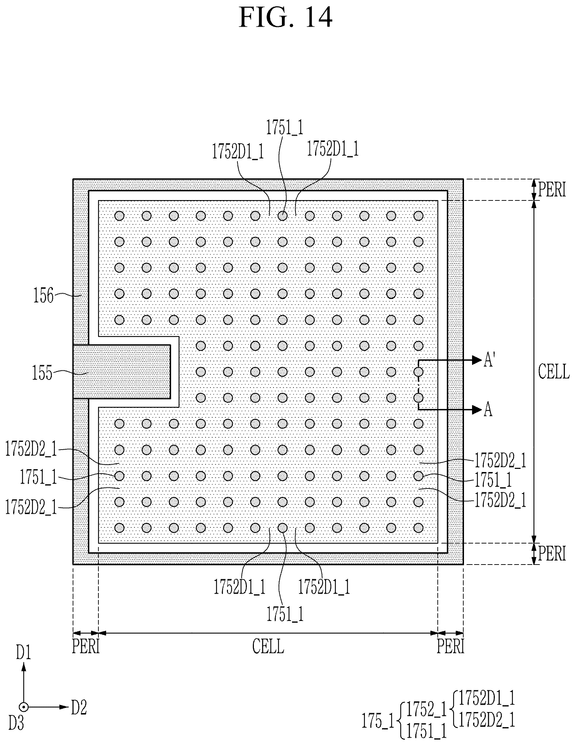

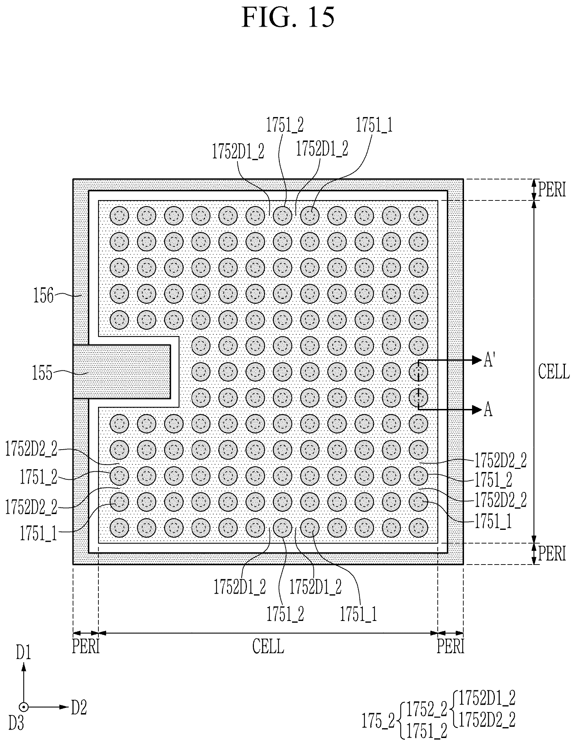

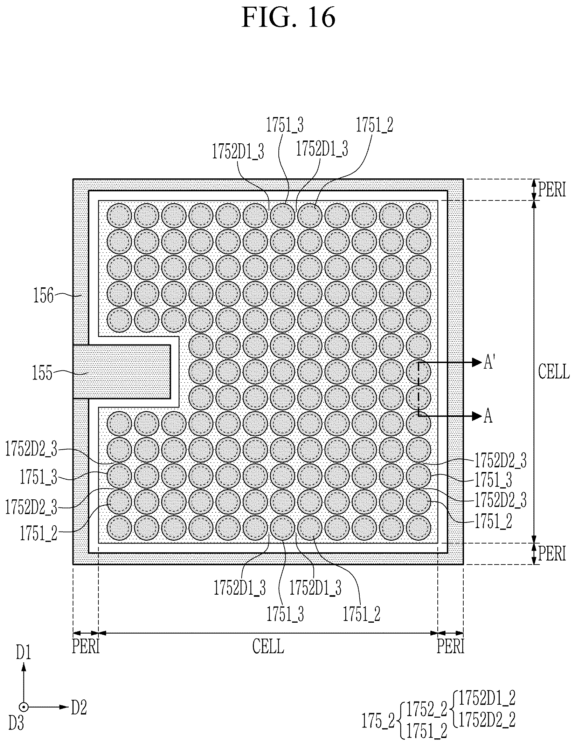

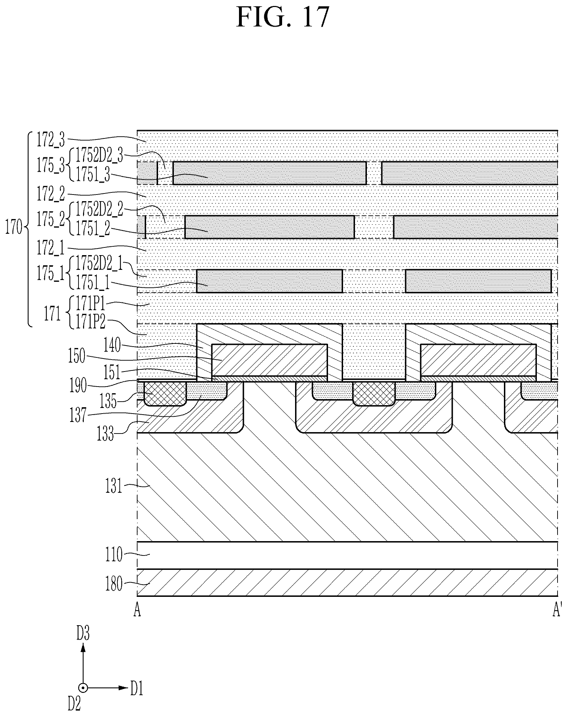

FIG. 14 is a plan view illustrating a 1st interlayer source electrode of a semiconductor device according to some implementations. FIG. 15 is a plan view showing the 2nd interlayer source electrode of the semiconductor device of FIG. 14. FIG. 16 is a plan view showing the 3rd interlayer source electrode of the semiconductor device of FIG. 14. FIG. 17 is a cross-sectional view taken along line A-A' of FIG. 16.

The implementations illustrated in FIGS. 14 to 17 have substantially the same parts as the implementations illustrated in FIGS. 1 and 2 or FIGS. 12 and 13, and thus descriptions thereof will be omitted and the differences will be mainly described. Additionally, the same reference numerals are used for the same elements as in the previous implementation.

For a clear understanding and simple illustration, FIG. 14 mainly illustrates the 1st first conductive lines 1752D1_1 and the 1st second conductive lines 1752D2_1 of the 1st conductive lines 1752_1 of the 1st interlayer source electrode 175_1, the 1st insulation structures 1751_1 of the 1st interlayer source electrode 175_1, the gate pad 155, and the gate wire 156, FIG. 15 mainly illustrates the 2nd first conductive lines 1752D1_2 and the 2nd second conductive lines 1752D2_2 of the 2nd conductive lines 1752_2 of the 2nd interlayer source electrode 175_2, the 2nd insulation structures 1751_2 of the 2nd interlayer source electrode 175_2, the 1st insulation structures 1751_1 of the 1st interlayer source electrode 175_1, the gate pad 155, and the gate wire 156, and FIG. 16 mainly illustrates the 3rd first conductive lines 1752D1_3 and the 3rd second conductive lines 1752D2_3 of the 3rd conductive lines 1752_3 of the 3rd interlayer source electrode 175_3, the 3rd insulation structures 1751_3 of the 3rd interlayer source electrode 175_3, the 2nd insulation structures 1751_2 of the 2nd interlayer source electrode 175_2, the gate pad 155, and the gate wire 156, and in FIGS. 14 to 16, the illustrations of the substrate 110, the first conductive semiconductor layer 131, the second conductivity type doped well region 133, the gate electrode 150, the gate insulation layer 151, the first source electrode 171 of the source electrode 170, the 1st interlayer source electrode 175_1, the 1st second source electrode 172_1, the 2nd interlayer source electrode 175_2, the 2nd second source electrode 172_2, and the 3rd second source electrode 172_3, and the drain electrode 180 are omitted.

Referring to FIGS. 14 to 17, the source electrode 170 may include multiple layers of second source electrodes 172_1, 172_2, and 172_3 and multiple layers of interlayer source electrodes 175_1, 175_2, and 175_3. The second source electrodes 172_1, 172_2, and 172_3 of multiple layers and the interlayer source electrodes 175_1, 175_2, and 175_3 of multiple layers may be alternately stacked in the third direction D3.

For example, the lengths of the 1st conductive lines 1752D1_1 of the 1st interlayer source electrode 175_1 along the second direction D2 may be greater than the lengths of the first conductive lines 1752D1_2 of the 2nd interlayer source electrode 175_2 along the second direction D2. The lengths of the first conductive lines 1752D1_2 of the 2nd interlayer source electrode 175_2 along the second direction D2 may be greater than the lengths of the first conductive lines 1752D1_3 of the 3rd interlayer source electrode 175_3 along the second direction D2. In other words, the lengths along the second direction D2 of the first conductive lines of the interlayer source electrode of one layer may be greater than the lengths along the second direction D2 of the first conductive lines of another interlayer source electrode located above the interlayer source electrode in the third direction D3, and may be less than the lengths along the second direction D2 of the first conductive lines of another interlayer source electrode located below the interlayer source electrode in the third direction D3. That is, the higher the interlayer source electrode 175 is disposed in the third direction D3, the shorter the lengths of the first conductive lines 1752D1 along the second direction D2.

Additionally, the lengths of the second conductive lines 1752D2_1 of the 1st interlayer source electrode 175_1 along the first direction D1 may be greater than the lengths of the second conductive lines 1752D2_2 of the 2nd interlayer source electrode 175_2 along the first direction D1. The lengths of the second conductive lines (1752D2_2) of the 2nd interlayer source electrode 175_2 along the first direction D1 may be greater than the lengths of the second conductive lines 1752D2_3 of the 3rd interlayer source electrode 175_3 along the first direction D1. In other words, the lengths along the first direction D1 of the second conductive lines of the interlayer source electrode of one layer may be greater than the lengths along the first direction D1 of the second conductive lines of the other interlayer source electrode located above the interlayer source electrode in the third direction D3 and may be less than the lengths along the first direction D1 of the second conductive lines of the other interlayer source electrode located below the interlayer source electrode in the third direction D3. That is, the higher the interlayer source electrode 175 is disposed in the third direction D3, the shorter the length of the second conductive lines 1752D2 along the first direction D1.

Additionally, the separation distance between the insulation structures 1751_1 of the 1st interlayer source electrode 175_1 along the first direction D1 or the second direction D2 may be greater than the separation distance between the insulation structures 1751_2 of the 2nd interlayer source electrode 175_2 along the first direction D1 or the second direction D2. The separation distance of the insulation structures 1751_2 of the 2nd interlayer source electrode 175_2 along the first direction D1 or the second direction D2 may be greater than the separation distance of the insulation structures 1751_3 of the 3rd interlayer source electrode 175_3 along the first direction D1 or the second direction D2. In other words, the separation distance along the first direction D1 or the second direction D2 of the insulation structures of the interlayer source electrodes of one layer may be greater than the separation distance along the first direction D1 or the second direction D2 of the insulation structures of the other interlayer source electrode(s) located above the interlayer source electrode in the third direction D3, and may be smaller than the separation distance along the first direction D1 or the second direction D2 of the insulation structures of the other interlayer source electrode(s) located below the interlayer source electrode in the third direction D3. That is, the higher the interlayer source electrode 175 is disposed in the third direction D3, the smaller the separation distance between the insulation structures 1751 in the first direction D1 or the second direction D2.

Additionally, the lengths of the insulation structures 1751_1 of the 1st interlayer source electrode 175_1 along the first direction D1 or the second direction D2 may be smaller than the lengths of the insulation structures 1751_2 of the 2nd interlayer source electrode 175_2 along the first direction D1 or the second direction D2. The lengths of the insulation structures 1751_2 of the 2nd interlayer source electrode 175_2 along the first direction D1 or the second direction D2 may be greater than the lengths of the insulation structures 1751_3 of the 3rd interlayer source electrode 175_3 along the first direction D1 or the second direction D2. In other words, the lengths along the first direction D1 or the second direction D2 of the insulation structures of the interlayer source electrode of one layer may be smaller than the lengths along the first direction D1 or the second direction D2 of the insulation structures of the other interlayer source electrode located above the interlayer source electrode in the third direction D3, and may be larger along the first direction D1 or the second direction D2 than the lengths of the insulation structures of the other interlayer source electrode located below the interlayer source electrode in the third direction D3. That is, the higher the interlayer source electrode 175 is disposed in the third direction D3, the longer the lengths of the insulation structures 1751 in the first direction D1 or the second direction D2 may be.

In this way, when the interlayer source electrode 175 is disposed higher in the third direction D3, the lengths of the first conductive lines 1752D1 along the second direction D2 becomes smaller, or the lengths of the second conductive lines 1752D2 along the first direction D1 becomes smaller, the required resistance may be adjusted.

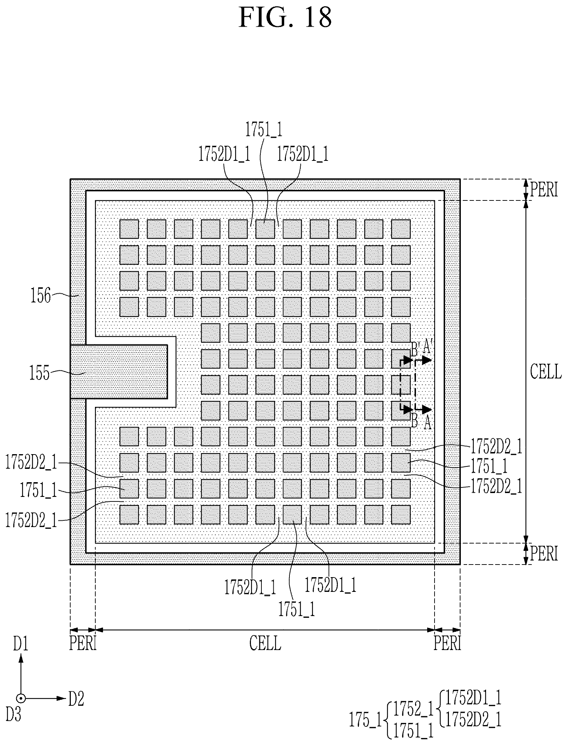

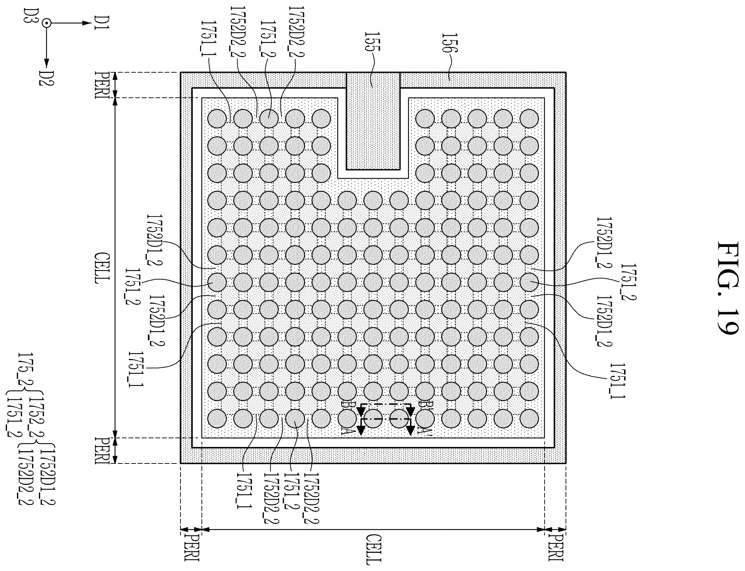

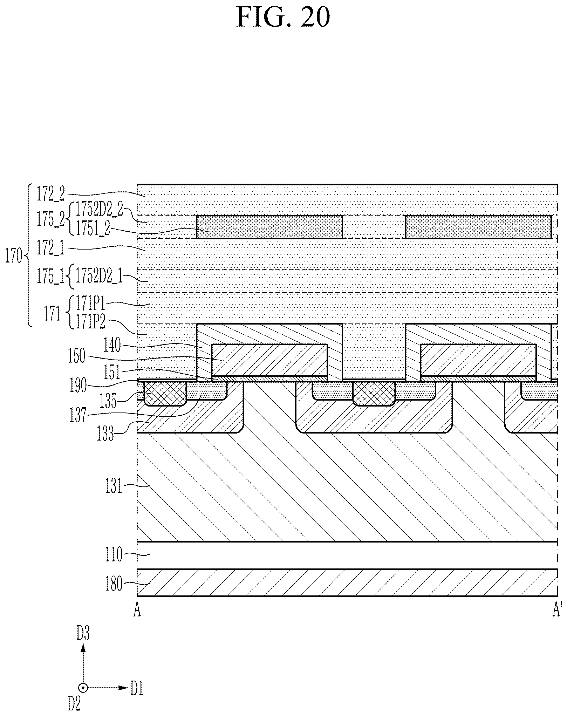

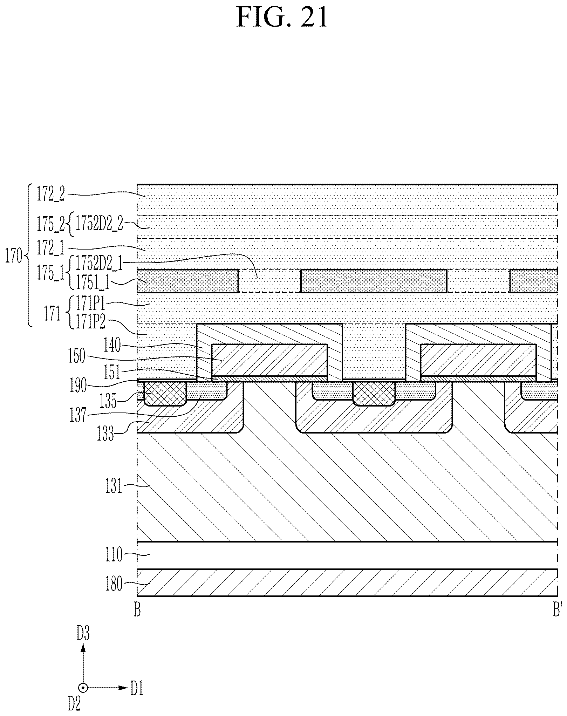

FIG. 18 is a plan view showing a 1st interlayer source electrode of a semiconductor device according to some implementations. FIG. 19 is a plan view showing the 2nd interlayer source electrode of the semiconductor device of FIG. 18. FIG. 20 is a cross-sectional view taken along line A-A' of FIG. 19. FIG. 21 is a cross-sectional view taken along line B-B' of FIG. 19.

The implementations illustrated in FIGS. 18 to 20 have substantially the same parts as the implementations illustrated in FIGS. 1 and 2 or 12 and 13, and thus descriptions thereof will be omitted and the differences will be mainly described. Additionally, the same reference numerals are used for the same elements as in the previous implementation.

For a clear understanding and a simple illustration, FIG. 18 mainly illustrates the 1st first conductive lines 1752D1_1 and the 1st second conductive lines 1752D2_1 of the 1st conductive lines 1752_1 of the 1st interlayer source electrode 175_1, the 1st insulation structures 1751_1 of the 1st interlayer source electrode 175_1, the gate pad 155, and the gate wire 156, and FIG. 19 mainly illustrates the 2nd first conductive lines 1752D1_2 and the 2nd second conductive lines 1752D2_2 of the 2nd conductive lines 1752_2 of the 2nd interlayer source electrode 175_2, the 2nd insulation structures 1751_2 of the 2nd interlayer source electrode 175_2, the 1st insulation structures 1751_1 of the 1st interlayer source electrode 175_1, the gate pad 155, and the gate wire 156, and in FIGS. 18 and 19, the illustrations of the substrate 110, the first conductivity type semiconductor layer 131, the second conductivity type doped well region 133, the gate electrode 150, the gate insulation layer 151, the first source electrode 171, the 1st second source electrode 172_1, the 2nd second source electrode 172_2, and the drain electrode 180 are omitted.

Referring to FIGS. 18 to 20, it is illustrated that the source electrode 170 includes two layers of second source electrodes 172_1 and 172_2 and two layers of interlayer source electrodes 175_1 and 175_2. In other words, the source electrode 170 may include a 1st interlayer source electrode 175_1 on the first source electrode 171, a 1st second source electrode 172_1 on the 1st interlayer source electrode 175_1, a 2nd interlayer source electrode 175_2 on the 1st second source electrode 172_1, and a 2nd second source electrode 172_2 on the 2nd interlayer source electrode 175_2.

The 1st interlayer source electrode 175_1 may include 1st insulation structures 1751_1, 1st first conductive lines 1752D1_1, and 1st second conductive lines 1752D2_1. The 2nd interlayer source electrode 175_2 may include 2nd insulation structures 1751_2, 2nd first conductive lines 1752D1_2, and 2nd second conductive lines 1752D2_2.

For example, the center points of the 1st insulation structures 1751_1 of the 1st interlayer source electrode 175_1 along the first direction D1 and the second direction D2 may not be overlapped in the third direction D3 with the center points of the 2nd insulation structures 1751_2 of the 2nd interlayer source electrode 175_2 along the first direction D1 and the second direction D2. In this case, the length of the current path may be further increased to reduce the saturation drain current (Idₛₐₜ) without changing the drain/source on-resistance (Rdsₒₙ), thereby preventing a short-circuit.

The center points of the 1st insulation structures 1751_1 of the 1st interlayer source electrode 175_1 along the first direction D1 and the second direction D2 may be overlapped in the third direction D3 with the center lines of the 2nd first conductive lines 1752D1_2 of the 2nd interlayer source electrode 175_2 along the second direction D2. The center points of the 1st insulation structures 1751_1 of the 1st interlayer source electrode 175_1 along the first direction D1 and the second direction D2 may be overlapped in the third direction D3 with the center lines of the 2nd second conductive lines 1752D2_2 of the 2nd interlayer source electrode 175_2 along the first direction D1.

Additionally, the center points of the 2nd insulation structures 1751_2 of the 2nd interlayer source electrode 175_2 along the first direction D1 and the second direction D2 may be overlapped in the third direction D3 with the center lines of the 1st first conductive lines 1752D1_1 of the 1st interlayer source electrode 175_1 along the second direction D2. The center points of the 2nd insulation structures 1751_2 of the 2nd interlayer source electrode 175_2 along the first direction D1 and the second direction D2 may be overlapped in the third direction D3 with the center lines of the 1st second conductive lines 1752D2_1 of the 1st interlayer source electrode 175_1 along the first direction D1.

The center lines of the 1st first conductive lines 1752D1_1 of the 1st interlayer source electrode 175_1 along the second direction D2 may not be overlapped in the third direction D3 with the center lines of the 2nd first conductive lines 1752D1_2 of the 2nd interlayer source electrode 175_2 along the second direction D2.

The center lines of the 1st second conductive lines 1752D2_1 of the 1st interlayer source electrode 175_1 along the first direction D1 may not be overlapped in the third direction D3 with the center lines of the second conductive lines 1752D2_2 of the 2nd interlayer source electrode 175_2 along the first direction D1.

In a plane extending in the first direction D1 and the second direction D2 perpendicular to the third direction D3 (e.g., FIGS. 18 and 19), the shapes of the 1st insulation structures 1751_1 of the 1st interlayer source electrode 175_1 and the 2nd insulation structures 1751_2 of the 2nd interlayer source electrode 175_2 may be different or substantially the same. In FIGS. 18 and 19, the planar shape of the 1st insulation structures 1751_1 of the 1st interlayer source electrode 175_1 is square, and the planar shape of the 2nd insulation structures 1751_2 of the 2nd interlayer source electrode 175_2 is circular. In some implementations, the shapes of the 1st insulation structures 1751_1 of the 1st interlayer source electrode 175_1 and the 2nd insulation structures 1751_2 of the 2nd interlayer source electrode 175_2 may independently have various shapes, such as circular, elliptical, polygonal, or line-shaped.

Additionally, in a plane extending in the first direction D1 and the second direction D2 perpendicular to the third direction D3 (for example, FIGS. 18 and 19), an area of the 1st insulation structures 1751_1 of the 1st interlayer source electrode 175_1 along the first direction D1 and the second direction D2 may be greater than, less than, or substantially equal to, an area of the 2nd insulation structures 1751_2 of the 2nd interlayer source electrode 175_2 along the first direction D1 and the second direction D2.

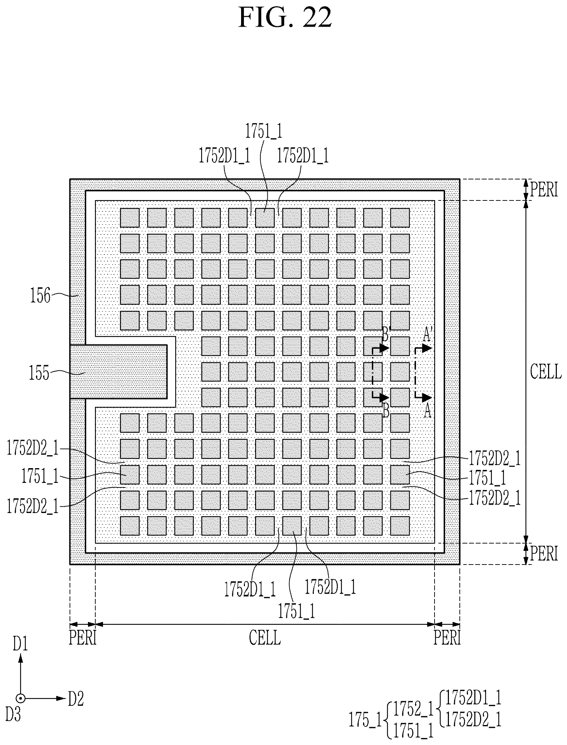

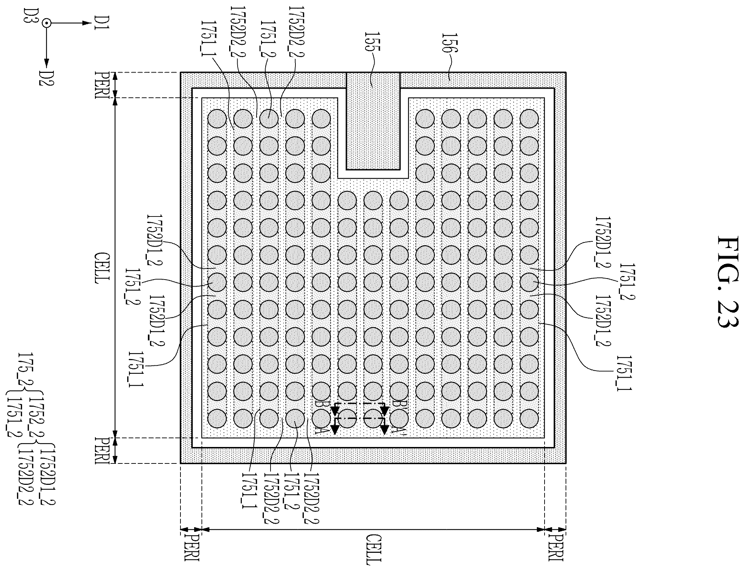

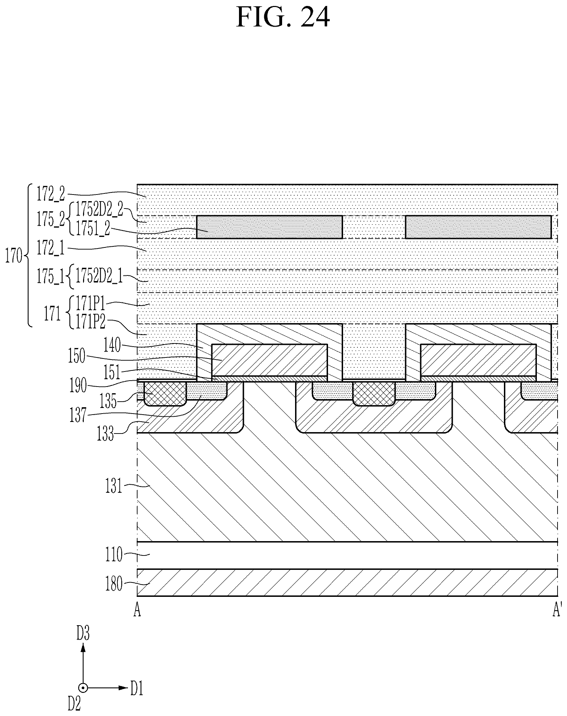

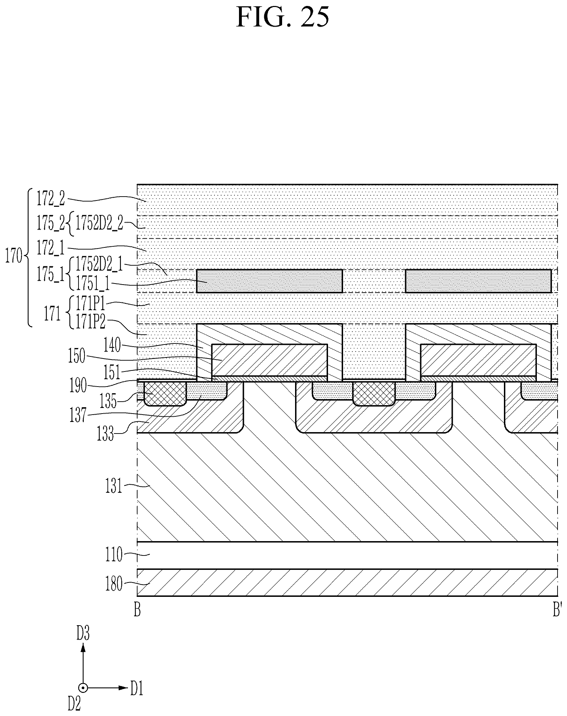

FIG. 22 is a plan view illustrating a 1st interlayer source electrode of a semiconductor device according to some implementations. FIG. 23 is a plan view showing the 2nd interlayer source electrode of the semiconductor device of FIG. 22. FIG. 24 is a cross-sectional view taken along line A-A' of FIG. 23. FIG. 25 is a cross-sectional view taken along line B-B' of FIG. 23.

The implementations illustrated in FIGS. 22 to 25 are substantially the same as the implementations illustrated in FIGS. 18 to 21, and thus descriptions thereof will be omitted and the differences will be mainly described. Additionally, the same reference numerals are used for the same elements as in the previous implementation.

For a clear understanding and simple illustration, FIG. 22 mainly illustrates the 1st first conductive lines 1752D1_1 and the 1st second conductive lines 1752D2_1 of the 1st conductive lines 1752_1 of the 1st interlayer source electrode 175_1, the 1st insulation structures 1751_1 of the 1st interlayer source electrode 175_1, the gate pad 155, and the gate wire 156, and FIG. 23 mainly illustrates the 2nd first conductive lines 1752D1_2 and the 2nd second conductive lines 1752D2_2 of the 2nd conductive lines 1752_2 of the 2nd interlayer source electrode 175_2, the 2nd insulation structures 1751_2 of the 2nd interlayer source electrode 175_2, the 1st insulation structures 1751_1 of the 1st interlayer source electrode 175_1, the gate pad 155, and the gate wire 156, and the illustrations of the substrate 110, the first conductivity type semiconductor layer 131, the second conductivity type doped well region 133, the gate electrode 150, the gate insulation layer 151, the first source electrode 171, the 1st second source electrode 172_1, the 2nd second source electrode 172_2, and the drain electrode 180 of FIGS. 22 and 23 are omitted.

Referring to FIGS. 22 to 25, the center points of the 1st insulation structures 1751_1 of the 1st interlayer source electrode 175_1 along the first direction D1 and the second direction D2 may not be overlapped in the third direction D3 with the center points of the 2nd insulation structures 1751_2 of the 2nd interlayer source electrode 175_2 along the first direction D1 and the second direction D2. In this case, the length of the current path may be further increased to reduce the saturation drain current (Idₛₐₜ) without changing the drain/source on-resistance (Rdsₒₙ), thereby preventing a short-circuit.

For example, the center points of the 1st insulation structures 1751_1 of the 1st interlayer source electrode 175_1 along the first direction D1 and the second direction D2 may be overlapped in the third direction D3 with the center lines of the 2nd first conductive lines 1752D1_2 of the 2nd interlayer source electrode 175_2 along the second direction D2. However, the center points of the 1st insulation structures 1751_1 of the 1st interlayer source electrode 175_1 along the first direction D1 and the second direction D2 may not be overlapped in the third direction D3 with the center lines of the 2nd second conductive lines 1752D2_2 of the 2nd interlayer source electrode 175_2 along the first direction D1.

Additionally, the center points of the 2nd insulation structures 1751_2 of the 2nd interlayer source electrode 175_2 along the first direction D1 and the second direction D2 may be overlapped in the third direction D3 with the center lines of the 1st first conductive lines 1752D1_1 of the 1st interlayer source electrode 175_1 along the second direction D2. However, the center points of the 2nd insulation structures 1751_2 of the 2nd interlayer source electrode 175_2 along the first direction D1 and the second direction D2 may not be overlapped in the third direction D3 with the center lines of the 1st second conductive lines 1752D2_1 of the 1st interlayer source electrode 175_1 along the first direction D1.

The center lines of the 1st first conductive lines 1752D1_1 of the 1st interlayer source electrode 175_1 along the second direction D2 may not be overlapped in the third direction D3 with the center lines of the 2nd first conductive lines 1752D1_2 of the 2nd interlayer source electrode 175_2 along the second direction D2. However, the center lines of the 1st second conductive lines 1752D2_1 of the 1st interlayer source electrode 175_1 along the first direction D1 may be overlapped in the third direction D3 with the center lines of the second conductive lines 1752D2_2 of the 2nd interlayer source electrode 175_2 along the first direction D1.

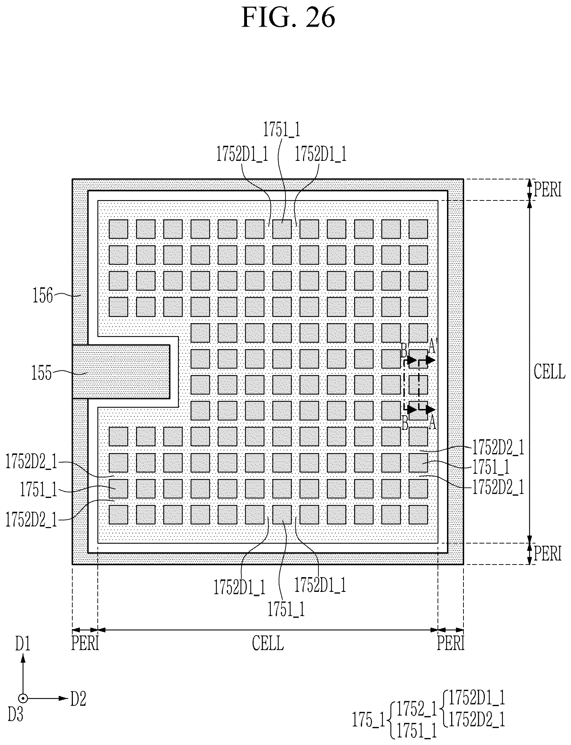

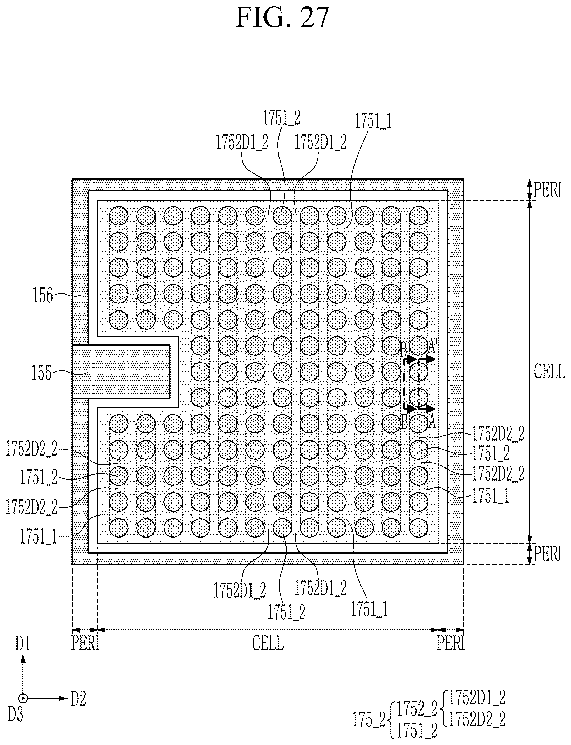

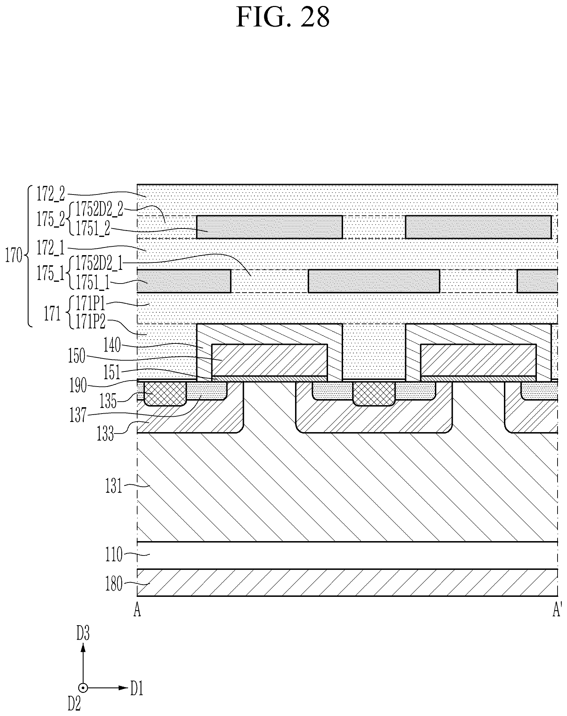

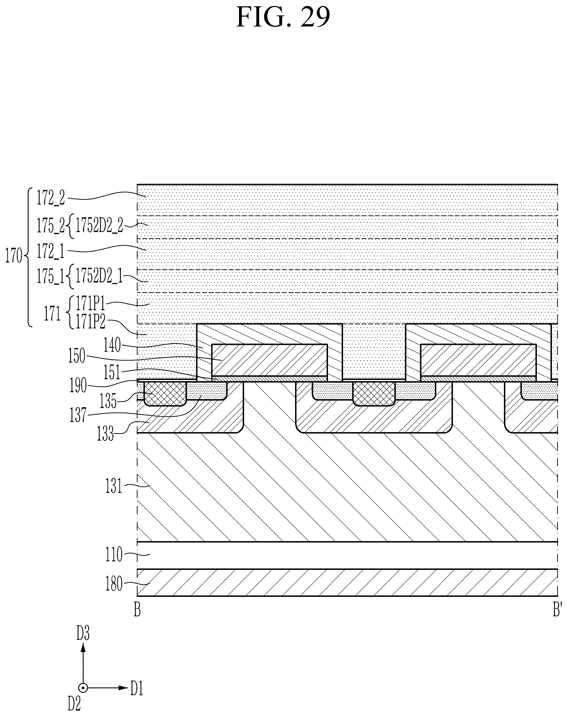

FIG. 26 is a plan view illustrating a 1st interlayer source electrode of a semiconductor device according to some implementations. FIG. 27 is a plan view showing the 2nd interlayer source electrode of the semiconductor device of FIG. 26. FIG. 28 is a cross-sectional view taken along line A-A' of FIG. 27. FIG. 29 is a cross-sectional view taken along line B-B' of FIG. 27.

The implementations illustrated in FIGS. 26 to 29 are substantially the same as the implementations illustrated in FIGS. 18 to 21, and thus descriptions thereof will be omitted and the differences will be mainly described. Additionally, the same reference numerals are used for the same elements as in the previous implementation.

For a clear understanding and a simple illustration, FIG. 26 mainly illustrates the 1st first conductive lines 1752D1_1 and the 1st second conductive lines 1752D2_1 of the 1st conductive lines 1752_1 of the 1st interlayer source electrode 175_1, the 1st insulation structures 1751_1 of the 1st interlayer source electrode 175_1, the gate pad 155, and the gate wire 156, and FIG. 27 mainly illustrates the 2nd first conductive lines 1752D1_2 and the 2nd second conductive lines 1752D2_2 of the 2nd conductive lines 1752_2 of the 2nd interlayer source electrode 175_2, the 2nd insulation structures 1751_2 of the 2nd interlayer source electrode 175_2, the 1st insulation structures 1751_1 of the 1st interlayer source electrode 175_1, the gate pad 155, and the gate wire 156, and in FIGS. 26 and 27, the illustrations of the substrate 110, the first conductivity type semiconductor layer 131, the second conductivity type doped well region 133, the gate electrode 150, the gate insulation layer 151, the first source electrode 171, the 1st second source electrode 172_1, the 2nd second source electrode 172_2, and the drain electrode 180 are omitted.

Referring to FIGS. 26 to 29, the center points of the 1st insulation structures 1751_1 of the 1st interlayer source electrode 175_1 along the first direction D1 and the second direction D2 may not be overlapped in the third direction D3 with the center points of the 2nd insulation structures 1751_2 of the 2nd interlayer source electrode 175_2 along the first direction D1 and the second direction D2. In this case, the length of the current path may be further increased to reduce the saturation drain current (Idₛₐₜ) without changing the drain/source on-resistance (Rdsₒₙ), thereby preventing a short-circuit.

For example, the center points of the 1st insulation structures 1751_1 of the 1st interlayer source electrode 175_1 along the first direction D1 and the second direction D2 may not be overlapped in the third direction D3 with the center lines of the 2nd first conductive lines 1752D1_2 of the 2nd interlayer source electrode 175_2 along the second direction D2. However, the center points of the 1st insulation structures 1751_1 of the 1st interlayer source electrode 175_1 along the first direction D1 and the second direction D2 may be overlapped in the third direction D3 with the center lines of the 2nd second conductive lines 1752D2_2 of the 2nd interlayer source electrode 175_2 along the first direction D1.

Additionally, the center points of the 2nd insulation structures 1751_2 of the 2nd interlayer source electrode 175_2 along the first direction D1 and the second direction D2 may not be overlapped in the third direction D3 with the center lines of the 1st first conductive lines 1752D1_1 of the 1st interlayer source electrode 175_1 along the second direction D2. However, the center points of the 2nd insulation structures 1751_2 of the 2nd interlayer source electrode 175_2 along the first direction D1 and the second direction D2 may be overlapped in the third direction D3 with the center lines of the 1st second conductive lines 1752D2_1 of the 1st interlayer source electrode 175_1 along the first direction D1.

The center lines of the 1st first conductive lines 1752D1_1 of the 1st interlayer source electrode 175_1 along the second direction D2 may be overlapped in the third direction D3 with the center lines of the first conductive lines 1752D1_2 of the 2nd interlayer source electrode 175_2 along the second direction D2. However, the center lines of the 1st second conductive lines 1752D2_1 of the 1st interlayer source electrode 175_1 along the first direction D1 may not be overlapped in the third direction D3 with the center lines of the second conductive lines 1752D2_2 of the 2nd interlayer source electrode 175_2 along the first direction D1.

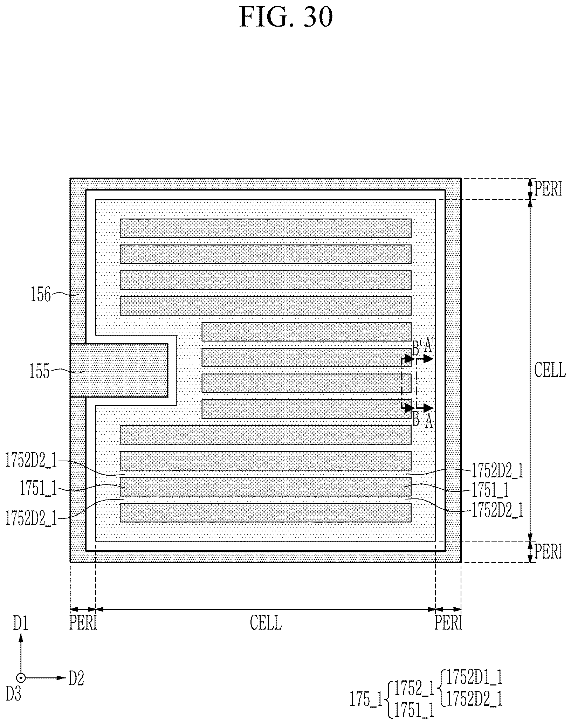

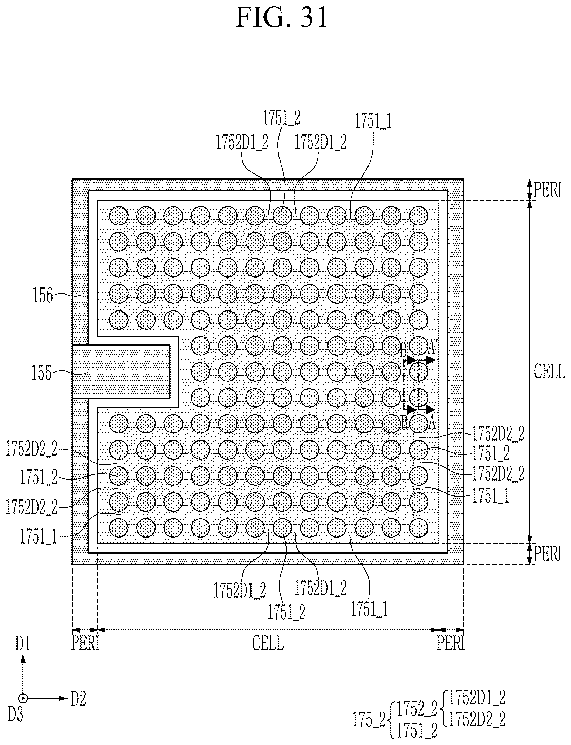

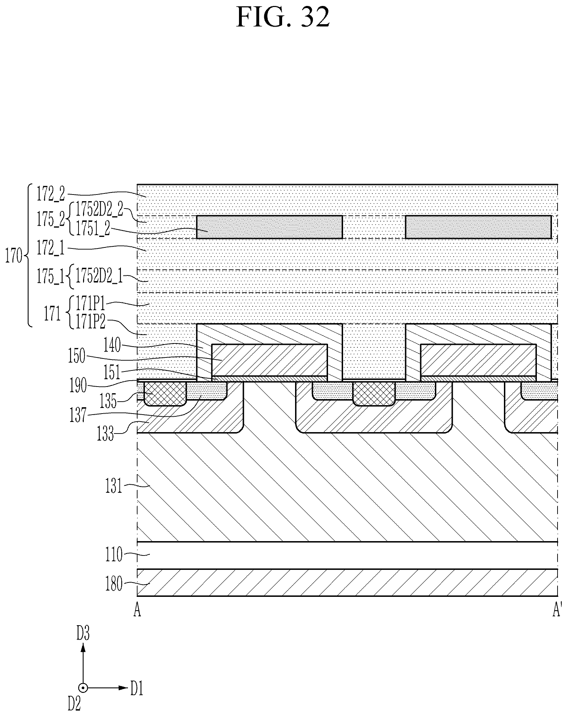

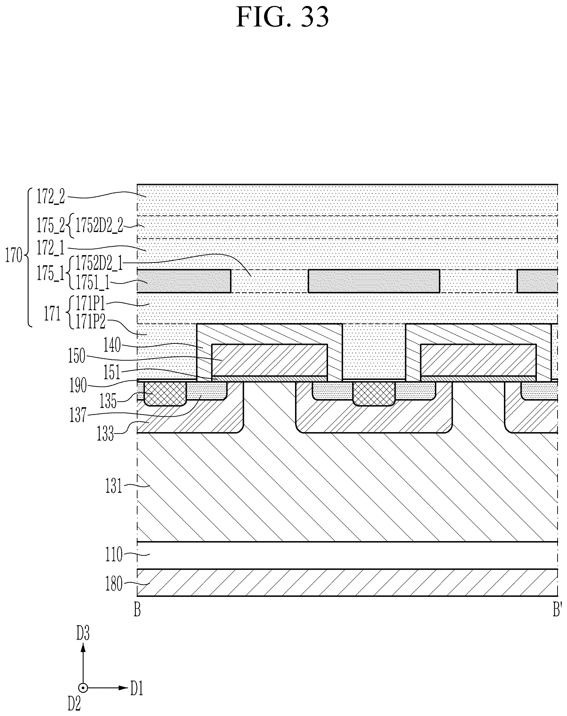

FIG. 30 is a plan view showing a 1st interlayer source electrode of a semiconductor device according to some implementations. FIG. 31 is a plan view showing the 2nd interlayer source electrode of the semiconductor device of FIG. 30. FIG. 32 is a cross-sectional view taken along line A-A' of FIG. 31. FIG. 33 is a cross-sectional view taken along line B-B' of FIG. 31.

The implementations illustrated in FIGS. 30 to 33 are substantially the same as the implementations illustrated in FIGS. 18 to 21, and thus a description thereof will be omitted and the differences will be mainly described. Additionally, the same reference numerals are used for the same elements as in the previous implementation.

For a clear understanding and a simple illustration, FIG. 30 mainly illustrates the 1st first conductive lines 1752D1_1 and the 1st second conductive lines 1752D2_1 of the 1st conductive lines 1752_1 of the 1st interlayer source electrode 175_1, the 1st insulation structures 1751_1 of the 1st interlayer source electrode 175_1, the gate pad 155, and the gate wire 156, and FIG. 31 mainly illustrates the 2nd first conductive lines 1752D1_2 and the 2nd second conductive lines 1752D2_2 of the 2nd conductive lines 1752_2 of the 2nd interlayer source electrode 175_2, the 2nd insulation structures 1751_2 of the 2nd interlayer source electrode 175_2, the 1st insulation structures 1751_1 of the 1st interlayer source electrode 175_1, the gate pad 155, and the gate wire 156, and in FIGS. 30 and 31, the illustrations of the substrate 110, the first conductivity type semiconductor layer 131, the second conductivity type doped well region 133, the gate electrode 150, the gate insulation layer 151, the first source electrode 171, the 1st second source electrode 172_1, the 2nd second source electrode 172_2, and the drain electrode 180 are omitted.

Referring to FIGS. 30 to 33, the source electrode 170 includes two layers of second source electrodes 172_1 and 172_2 and two layers of interlayer source electrodes 175_1 and 175_2. In other words, the source electrode 170 may include a 1st interlayer source electrode 175_1 on the first source electrode 171, a 1st second source electrode 172_1 on the 1st interlayer source electrode 175_1, a 2nd interlayer source electrode 175_2 on the 1st second source electrode 172_1, and a 2nd second source electrode 172_2 on the 2nd interlayer source electrode 175_2.

The 1st interlayer source electrode 175_1 may include 1st insulation structures 1751_1 and 1st second conductive lines 1752D2_1. The 2nd interlayer source electrode 175_2 may include 2nd insulation structures 1751_2, 2nd first conductive lines 1752D1_2, and 2nd second conductive lines 1752D2_2.

For example, in a plane (e.g., FIGS. 30 and 31) extending in the first direction D1 and the second direction D2 perpendicular to the third direction D3, the 1st insulation structures 1751_1 of the 1st interlayer source electrode 175_1 are illustrated as having a line shape extending in the second direction D2 and being spaced apart in the first direction D1. The 1st insulation structures 1751_1 of the 1st interlayer source electrode 175_1 may have different lengths along the second direction D2 and along the first direction D1. In some implementations, the 1st insulation structures 1751_1 of the 1st interlayer source electrode 175_1 may have a line shape extending in the first direction D1 and spaced apart in the second direction D2. Accordingly, the 1st interlayer source electrode 175_1 may have 1st second conductive lines 1752D2_1 extending in the second direction D2 and spaced apart from each other in the first direction D1, but may not have 1st first conductive lines 1752D1_1 extending in the first direction D1 and spaced apart from each other in the second direction D2.

In addition, in a plane extending in the first direction D1 and the second direction D2 perpendicular to the third direction D3 (e.g., FIGS. 30 and 31), the 2nd insulation structures 1751_2 of the 2nd interlayer source electrode 175_2 are illustrated as having a circular shape in the plane. The 2nd insulation structures 1751_2 of the 2nd interlayer source electrode 175_2 may have a length along the second direction D2 and a length along the first direction D1 which are substantially the same. In some implementations, the shapes of the 2nd insulation structures 1751_2 of the 2nd interlayer source electrode 175_2 may each independently have various shapes, such as a circle, an ellipse, a polygon, or a line shape.

In some implementations, the 2nd insulation structures 1751_2 of the 2nd interlayer source electrode 175_2 may have a line shape in planar shape, and the 1st insulation structures 1751_1 of the 1st interlayer source electrode 175_1 may have a circular shape in planar shape. The 1st insulation structures 1751_1 of the 1st interlayer source electrode 175_1 may have substantially the same length in the second direction D2 and the same length in the first direction D1, and the 2nd insulation structures 1751_2 of the 2nd interlayer source electrode 175_2 may have different lengths in the second direction D2 and the same length in the first direction D1.

The center lines of the 1st insulation structures 1751_1 of the 1st interlayer source electrode 175_1 along the first direction D1 may or may not be overlapped in the third direction D3 with the center points of the 2nd insulation structures 1751_2 of the 2nd interlayer source electrode 175_2 along the first direction D1 and the second direction D2. In FIGS. 30 to 33, the center lines of the 1st insulation structures 1751_1 of the 1st interlayer source electrode 175_1 along the first direction D1 may not be overlapped in the third direction D3 with the center points of the 2nd insulation structures 1751_2 of the 2nd interlayer source electrode 175_2 along the first direction D1 and the second direction D2.

In this way, when the center lines of the 1st insulation structures 1751_1 of the 1st interlayer source electrode 175_1 along the first direction D1 are not overlapped in the third direction D3 with the center points of the 2nd insulation structures 1751_2 of the 2nd interlayer source electrode 175_2 along the first direction D1 and the second direction D2, the length of the current path is further increased, thereby reducing the saturated drain current (Idₛₐₜ) without changing the drain/source on-resistance (Rdsₒₙ), thereby preventing a short-circuit.

In some implementations, when the center lines of the 1st insulation structures 1751_1 of the 1st interlayer source electrode 175_1 along the first direction D1 are overlapped in the third direction D3 with the center points of the 2nd insulation structures 1751_2 of the 2nd interlayer source electrode 175_2 along the first direction D1 and the second direction D2, as the 1st insulation structures 1751_1 of the 1st interlayer source electrode 175_1 extend in the second direction D2, any one of the 1st insulation structures 1751_1 may be overlapped in the third direction D3 with the center points of the 2nd insulation structures 1751_2 along the first direction D1 and the second direction D2.

The center lines of the 1st insulation structures 1751_1 of the 1st interlayer source electrode 175_1 along the first direction D1 may be overlapped in the third direction D3 with the center lines of the 2nd first conductive lines 1752D1_2 of the 2nd interlayer source electrode 175_2 along the second direction D2. The center lines of the 1st insulation structures 1751_1 of the 1st interlayer source electrode 175_1 along the first direction D1 may be overlapped in the third direction D3 with the center lines of the 2nd second conductive lines 1752D2_2 of the 2nd interlayer source electrode 175_2 along the first direction D1.

Additionally, the center points of the 2nd insulation structures 1751_2 of the 2nd interlayer source electrode 175_2 along the first direction D1 and the second direction D2 may be overlapped in the third direction D3 with the center lines of the 1st second conductive lines 1752D2_1 of the 1st interlayer source electrode 175_1 along the first direction D1.

The center lines of the 1st second conductive lines 1752D2_1 of the 1st interlayer source electrode 175_1 along the first direction D1 may be overlapped in the third direction D3 with the center lines of the 2nd second conductive lines 1752D2_2 of the 2nd interlayer source electrode 175_2 along the first direction D1. The center lines of the 1st second conductive lines 1752D2_1 of the 1st interlayer source electrode 175_1 along the first direction D1 may be overlapped in the third direction D3 with the center lines of the 2nd first conductive lines 1752D1_2 of the 2nd interlayer source electrode 175_2 along the second direction D2.

Embodiments are set out in the following Clauses:
Clause 1. A semiconductor device, comprising
   a substrate comprising a cell region and a peripheral region located outside the cell region,
   a first conductivity type semiconductor layer on an upper surface of the substrate,
   a second conductivity type doped well region within the first conductivity type semiconductor layer,
   a gate electrode on the first conductivity type semiconductor layer,
   a gate insulation layer between the first conductivity type semiconductor layer and the gate electrode,
   a source electrode on the second conductivity type doped well region, and
   a drain electrode under a lower surface of the substrate,
   wherein the source electrode comprises
   a first source electrode on the gate electrode,
   a second source electrode on the first source electrode, and
   an interlayer source electrode comprising insulation structures spaced apart in a first direction parallel to the upper surface of the substrate and conductive lines between the insulation structures, and disposed between the first source electrode and the second source electrode.
Clause 2. The semiconductor device of Clause 1, wherein
   the insulation structures are spaced apart in the first direction and in a second direction parallel to the upper surface of the substrate and different from the first direction,
   the conductive lines comprise
   first conductive lines extending in the first direction and spaced apart in the second direction with the insulation structures interposed therebetween, and
   second conductive lines extending in the second direction and spaced apart in the first direction with the insulation structures interposed therebetween, and
   the first conductive lines and the second conductive lines intersect each other.
Clause 3. The semiconductor device of Clause 2, wherein
   the first conductive lines and the second conductive lines are connected to each other and surround the insulation structures, and
   the first conductive lines and the second conductive lines extend in a third direction perpendicular to the upper surface of the substrate to connect the first source electrode and the second source electrode.
Clause 4. The semiconductor device of Clause 3, wherein
   the first source electrode has
   a first portion on the gate electrode, and
   a second portion extending downward in the third direction from the first portion, disposed between the gate electrodes, and connected to the second conductivity type doped well region.
Clause 5. The semiconductor device of Clause 4, wherein
   the center line of the first conductive line along the second direction is overlapped with the second portion of the first source electrode in the third direction, or
   the center line of the second conductive line along the first direction is overlapped with the second portion of the first source electrode in the third direction, and
   the center point of the insulation structure along the first direction and the second direction is not overlapped with the second portion of the first source electrode in the third direction.
Clause 6. The semiconductor device of Clause 4, wherein
   the center line of the first conductive line along the second direction is not overlapped with the second portion of the first source electrode in the third direction, or
   the center line of the second conductive line along the first direction is not overlapped with the second portion of the first source electrode in the third direction, and
   the center point of the insulation structure along the first direction and the second direction is overlapped with the second portion of the first source electrode in the third direction.
Clause 7. The semiconductor device of any of Clauses 4-6, wherein
   the insulation structure has a circular, oval, polygonal shape, a line shape extending in the first direction, or a line shape extending in the second direction on a plane.
Clause 8. The semiconductor device of any of Clauses 3-7, wherein
   the semiconductor device further comprises a gate pad or gate wire in the peripheral region of the substrate,
   the interlayer source electrode comprises a first insulation structure located closer to the peripheral region in the first direction and the second direction, and a second insulation structure located farther away from the peripheral region in the first direction and the second direction, and
   an area of the first insulation structure along the first direction and the second direction is smaller than an area of the second insulation structure along the first direction and the second direction.
Clause 9. The semiconductor device of any of Clauses 3-8, wherein
   the first conductive lines comprise first conductive overlapping lines in which the center lines of the first conductive lines along the second direction are overlapped with the second portion of the first source electrode in the third direction, and first conductive non-overlapping lines in which the center lines of the first conductive lines along the second direction are not overlapped with the second portion of the first source electrode in the third direction, and a length of the first conductive overlapping lines along the second direction is smaller than a length of the first conductive non-overlapping lines along the second direction, or
   the second conductive lines comprise second conductive overlapping lines in which the center lines of the second conductive lines along the first direction are overlapped with the second portion of the first source electrode in the third direction, and second conductive non-overlapping lines in which the center lines of the second conductive lines along the first direction are not overlapped with the second portion of the first source electrode in the third direction, and a length of the second conductive overlapping lines along the first direction is smaller than a length of the second conductive non-overlapping lines along the first direction.
Clause 10. A semiconductor device, comprising
   a substrate comprising a cell region and a peripheral region located outside the cell region,
   a first conductivity type semiconductor layer on an upper surface of the substrate,
   a second conductivity type doped well region within the first conductivity type semiconductor layer,
   a gate electrode on the first conductivity type semiconductor layer,
   a gate insulation layer between the first conductivity type semiconductor layer and the gate electrode,
   a source electrode on the second conductivity type doped well region, and
   a drain electrode under a lower surface of the substrate,
   wherein the source electrode comprises
   a first source electrode on the gate electrode,
   a second source electrode on the first source electrode, and
   an interlayer source electrode comprising insulation structures spaced apart in a first direction parallel to the upper surface of the substrate and conductive lines between the insulation structures, and disposed between the first source electrode and the second source electrode,
   the source electrode comprises multiple layers of the second source electrodes and multiple layers of the interlayer source electrodes, and
   the second source electrodes and the interlayer source electrodes are alternately stacked in the third direction.
Clause 11. The semiconductor device of Clause 10, wherein
   the source electrode comprises
   2 to 100 layers of the second source electrodes, and
   2 to 100 layers of the interlayer source electrodes.
Clause 12. The semiconductor device of Clause 10 or Clause 11, wherein
   the insulation structures are spaced apart in the first direction and in a second direction parallel to the upper surface of the substrate and different from the first direction,
   the conductive lines comprise
   first conductive lines extending in the first direction and spaced apart in the second direction with the insulation structures interposed therebetween, and
   second conductive lines extending in the second direction and spaced apart in the first direction with the insulation structures interposed therebetween, and
   the first conductive lines and the second conductive lines intersect each other.
Clause 13. The semiconductor device of Clause 12, wherein
   a length of the first conductive lines of the interlayer source electrode of one of the above layers along the second direction is greater than a length of the first conductive lines of another interlayer source electrode located above the third direction of the interlayer source electrode along the second direction, and is less than a length of the first conductive lines of another interlayer source electrode located below the third direction of the interlayer source electrode along the second direction, or
   a length of the second conductive lines of the interlayer source electrode of one of the above layers along the first direction is greater than a length of the second conductive lines of another interlayer source electrode located above the third direction of the interlayer source electrode along the first direction, and is less than a length of the second conductive lines of another interlayer source electrode located below the third direction of the interlayer source electrode along the first direction, and
   a separation distance of the insulation structures of the interlayer source electrodes of any one of the layers along the first direction or the second direction is greater than a separation distance of the insulation structures of the other interlayer source electrodes located above the third direction of the interlayer source electrode along the first direction or the second direction, and is smaller than the separation distance of the insulation structures of the other interlayer source electrodes located below the third direction of the interlayer source electrode along the first direction or the second direction.
Clause 14.The semiconductor device of Clause 12 or Clause 13, wherein
   the source electrode further comprises
   a first source electrode on the gate electrode,
   a 1st interlayer source electrode disposed on the first source electrode and comprising insulation structures spaced apart in a first direction parallel to the upper surface of the substrate and conductive lines disposed between the insulation structures,
   a 1st second source electrode on the 1st interlayer source electrode,
   a 2nd interlayer source electrode located on the 1st second source electrode and comprising insulation structures spaced apart in a first direction parallel to the upper surface of the substrate and conductive lines between the insulation structures,
   a 2nd second source electrode on the 2nd interlayer source electrode,
   a 3rd interlayer source electrode located on the 2nd second source electrode and comprising insulation structures spaced apart in a first direction parallel to the upper surface of the substrate and conductive lines between the insulation structures, and
   a 3rd second source electrode on the 3rd interlayer source electrode,
   wherein a length of the first conductive lines of the 1st interlayer source electrode along the second direction is greater than a length of the first conductive lines of the 2nd interlayer source electrode along the second direction, and a length of the first conductive lines of the 2nd interlayer source electrode along the second direction is greater than a length of the first conductive lines of the 3rd interlayer source electrode along the second direction, or
   a length of the second conductive lines of the 1st interlayer source electrode along the first direction is greater than a length of the second conductive lines of the 2nd interlayer source electrode along the first direction, and a length of the second conductive lines of the 2nd interlayer source electrode along the first direction is greater than a length of the second conductive lines of the 3rd interlayer source electrode along the first direction, and
   a separation distance of the insulation structures of the 1st interlayer source electrode along the first direction or the second direction is greater than a separation distance of the insulation structures of the 2nd interlayer source electrode along the first direction or the second direction, and a separation distance of the insulation structures of the 2nd interlayer source electrode along the first direction or the second direction is greater than a separation distance of the insulation structures of the 3rd interlayer source electrode along the first direction or the second direction.
Clause 15. A semiconductor device, comprising
   a substrate comprising a cell region and a peripheral region located outside the cell region,
   a first conductivity type semiconductor layer on an upper surface of the substrate,
   a second conductivity type doped well region within the first conductivity type semiconductor layer,
   a gate electrode on the first conductivity type semiconductor layer,
   a gate insulation layer between the first conductivity type semiconductor layer and the gate electrode,
   a source electrode on the second conductivity type doped well region, and
   a drain electrode under a lower surface of the substrate,
   wherein the source electrode comprises
   a first source electrode on the gate electrode,
   a 1st interlayer source electrode disposed on the first source electrode and comprising insulation structures spaced apart in a first direction parallel to the upper surface of the substrate and conductive lines disposed between the insulation structures,
   a 1st second source electrode on the 1st interlayer source electrode,
   a 2nd interlayer source electrode disposed on the 1st second source electrode, and comprising insulation structures spaced apart in the first direction and conductive lines between the insulation structures, and
   a 2nd second source electrode on the 2nd interlayer source electrode, and
   center points of the insulation structures of the 1st interlayer source electrode along the first direction and the second direction, which are parallel to the upper surface of the substrate and different from the first direction, are not overlapped with center points of the insulation structures of the 2nd interlayer source electrode along the first direction and the second direction in the third direction perpendicular to the upper surface of the substrate.
Clause 16. The semiconductor device of Clause 15, wherein
   the insulation structures are disposed spaced apart in the first direction and the second direction,
   the conductive lines comprise
   first conductive lines extending in the first direction and spaced apart in the second direction with the insulation structures interposed therebetween, and
   second conductive lines extending in the second direction and spaced apart in the first direction with the insulation structures interposed therebetween, and
   the first conductive lines and the second conductive lines intersect each other.
Clause 17.The semiconductor device of Clause 16, wherein
   the center points of the insulation structures of the 1st interlayer source electrode along the first direction and the second direction are overlapped with the center lines of the first conductive lines of the 2nd interlayer source electrode along the second direction in the third direction,
   the center points of the insulation structures of the 1st interlayer source electrode along the first direction and the second direction are overlapped with the center lines of the second conductive lines of the 2nd interlayer source electrode along the first direction in the third direction,
   the center points of the insulation structures of the 2nd interlayer source electrode along the first direction and the second direction are overlapped with the center lines of the first conductive lines of the 1st interlayer source electrode along the second direction in the third direction,
   the center points of the insulation structures of the 2nd interlayer source electrode along the first direction and the second direction are overlapped with the center lines of the second conductive lines of the 1st interlayer source electrode along the first direction in the third direction,
   the center lines of the first conductive lines of the 1st interlayer source electrode along the second direction are not overlapped with the center lines of the first conductive lines of the 2nd interlayer source electrode along the second direction in the third direction, and
   the center lines of the second conductive lines of the 1st interlayer source electrode along the first direction are not overlapped with the center lines of the second conductive lines of the 2nd interlayer source electrode along the first direction in the third direction.
Clause 18.The semiconductor device of Clause 16 or Clause 17, wherein
   the center points of the insulation structures of the 1st interlayer source electrode along the first direction and the second direction are overlapped with the center lines of the first conductive lines of the 2nd interlayer source electrode along the second direction in the third direction,
   the center points of the insulation structures of the 1st interlayer source electrode along the first direction and the second direction are not overlapped with the center lines of the second conductive lines of the 2nd interlayer source electrode along the first direction in the third direction,
   the center points of the insulation structures of the 2nd interlayer source electrode along the first direction and the second direction are overlapped with the center lines of the first conductive lines of the 1st interlayer source electrode along the second direction in the third direction,
   the center points of the insulation structures of the 2nd interlayer source electrode along the first direction and the second direction are not overlapped with the center lines of the second conductive lines of the 1st interlayer source electrode along the first direction in the third direction,
   the center lines of the first conductive lines of the 1st interlayer source electrode along the second direction are not overlapped with the center lines of the first conductive lines of the 2nd interlayer source electrode along the second direction in the third direction, and
   the center lines of the second conductive lines of the 1st interlayer source electrode along the first direction are overlapped with the center lines of the second conductive lines of the 2nd interlayer source electrode along the first direction in the third direction.
Clause 19.The semiconductor device of any of Clauses 16-18, wherein
   the center points of the insulation structures of the 1st interlayer source electrode along the first direction and the second direction are not overlapped with the center lines of the first conductive lines of the 2nd interlayer source electrode along the second direction in the third direction,
   the center points of the insulation structures of the 1st interlayer source electrode along the first direction and the second direction are overlapped with the center lines of the second conductive lines of the 2nd interlayer source electrode along the first direction in the third direction,
   the center points of the insulation structures of the 2nd interlayer source electrode along the first direction and the second direction are not overlapped with the center lines of the first conductive lines of the 1st interlayer source electrode along the second direction in the third direction,
   the center points of the insulation structures of the 2nd interlayer source electrode along the first direction and the second direction are overlapped with the center lines of the second conductive lines of the 1st interlayer source electrode along the first direction in the third direction,
   the center lines of the first conductive lines of the 1st interlayer source electrode along the second direction are overlapped with the center lines of the first conductive lines of the 2nd interlayer source electrode along the second direction in the third direction, and
   the center lines of the second conductive lines of the 1st interlayer source electrode along the first direction are not overlapped with the center lines of the second conductive lines of the 2nd interlayer source electrode along the first direction in the third direction.
Clause 20.The semiconductor device of any of Clauses 15-19, wherein
   the insulation structures of the 1st interlayer source electrode extend in the second direction and are disposed spaced apart from each other in the first direction, and the conductive lines of the 1st interlayer source electrode comprise first conductive lines that extend in the second direction and are disposed spaced apart from each other in the first direction with the insulation structures interposed therebetween, and
   the insulation structures of the 2nd interlayer source electrode are disposed to be spaced apart in the first direction and the second direction, and the conductive lines of the 2nd interlayer source electrode comprise first conductive lines extending in the first direction and disposed to be spaced apart in the second direction with the insulation structures therebetween, and second conductive lines extending in the second direction and disposed to be spaced apart in the first direction with the insulation structures therebetween, and the first conductive lines and the second conductive lines intersect each other,
   the center lines of the insulation structures of the 1st interlayer source electrode along the first direction are overlapped with the center lines of the first conductive lines of the 2nd interlayer source electrode along the second direction in the third direction,
   the center lines of the insulation structures of the 1st interlayer source electrode along the first direction are overlapped with the center lines of the second conductive lines of the 2nd interlayer source electrode along the first direction in the third direction,
   the center points of the insulation structures of the 2nd interlayer source electrode along the first direction and the second direction are overlapped with the center lines of the first conductive lines of the 1st interlayer source electrode along the second direction in the third direction,
   the center points of the insulation structures of the 2nd interlayer source electrode along the first direction and the second direction are overlapped with the center lines of the second conductive lines of the 1st interlayer source electrode along the first direction in the third direction, and
   the center lines of the second conductive lines of the 1st interlayer source electrode along the first direction are not overlapped with the center lines of the second conductive lines of the 2nd interlayer source electrode along the first direction in the third direction.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While this disclosure has been described in connection with what is presently considered to be practical implementations, it is to be understood that the disclosure is not limited to the disclosed implementations, but, on the contrary, is intended to cover various modifications and equivalent arrangements included within the scope of the appended claims.

## Claims

1. A semiconductor device comprising:
a substrate (110) comprising a cell region and a peripheral region located outside the cell region;
a first conductivity type semiconductor layer (131) on an upper surface of the substrate (110);
a second conductivity type doped well region (133) within the first conductivity type semiconductor layer (131);
a gate electrode (150) on the first conductivity type semiconductor layer (131);
a gate insulation layer (151) between the first conductivity type semiconductor layer (131) and the gate electrode (150);
a source electrode (170) on the second conductivity type doped well region (133); and
a drain electrode (180) under a lower surface of the substrate (110),
wherein the source electrode (170) comprises
a first source electrode (171) on the gate electrode (150),
a second source electrode (172) on the first source electrode (171), and
an interlayer source electrode (175) comprising (i) a plurality of insulation structures (1751) that are spaced apart from one another in a first direction parallel to the upper surface of the substrate (110) and (ii) a plurality of conductive lines (1752), wherein each conductive line (1752) of the plurality of conductive lines (1752) is between adjacent insulation structures (1751) of the plurality of insulation structures (1751), and wherein the interlayer source electrode (175) is disposed between the first source electrode (171) and the second source electrode (172).

2. The semiconductor device of claim 1, wherein the plurality of insulation structures (1751) are spaced apart from one another in a second direction that is parallel to the upper surface of the substrate (110) and that is different from the first direction,
wherein the plurality of conductive lines (1752) comprise
a plurality of first conductive lines (1752D1) extending in the first direction and spaced apart from one another in the second direction, wherein each insulation structure (1751) of the plurality of insulation structures is interposed between adjacent first conductive lines (1752D1) of the plurality of first conductive lines (1752D1), and
a plurality of second conductive lines (1752D2) extending in the second direction and spaced apart from one another in the first direction, wherein each insulation structure (1751) of the plurality of insulation structures (1751) is interposed between adjacent second conductive lines (1752D2) of the plurality of second conductive lines (1752D2), and
wherein the plurality of first conductive lines (1752D1) intersect with the plurality of the second conductive lines (1752D2).

3. The semiconductor device of claim 2, wherein the plurality of first conductive lines (1752D1) and the plurality of second conductive lines (1752D2) are connected to each other and surround the plurality of insulation structures (1751), and
wherein the plurality of the first conductive lines (1752D1) and the plurality of second conductive lines (1752D2) extend in a third direction perpendicular to the upper surface of the substrate (110), thereby connecting the first source electrode (171) to the second source electrode (172).

4. The semiconductor device of claim 2 or claim 3, wherein the first source electrode (171) comprises:
a first portion (171P1) on the gate electrode (150); and
a second portion (171P2) that extends downward in the third direction from the first portion (171P1), that is disposed between gate electrodes (150), and that is connected to the second conductivity type doped well region (133).

5. The semiconductor device of claim 4, wherein (i) a center line of each first conductive line (1752D1) of the plurality of first conductive lines (1752D1) along the second direction overlaps with the second portion (171P2) of the first source electrode (171) in the third direction, and/or (ii) a center line of each second conductive line (1752D2) of the plurality of second conductive lines (1752D2) along the first direction overlaps with the second portion (171P2) of the first source electrode (171) in the third direction, and
wherein a center point of each insulation structure (1751) of the plurality of insulation structures (1751) along the first direction and the second direction does not overlap with the second portion (171P2) of the first source electrode (171) in the third direction; or
wherein (i) a center line of each first conductive line (1752D1) of the plurality of first conductive lines (1752D1) along the second direction does not overlap with the second portion (171P2) of the first source electrode (171) in the third direction, and/or (ii) a center line of each second conductive line (1752D2) of the plurality of second conductive lines (1752D2) along the first direction does not overlap with the second portion (171P2) of the first source electrode (171) in the third direction, and
wherein a center point of each insulation structure (1751) of the plurality of insulation structures (1751) along the first direction and the second direction overlaps with the second portion (171 P2) of the first source electrode (171) in the third direction; and/or
wherein each insulation structure (1751) of the plurality of insulation structures (1751) has one of (i) a circular shape, (ii) an oval shape, (iii) a polygonal shape, (iv) a line shape extending in the first direction, or (v) a line shape extending in the second direction on a plane.

6. The semiconductor device of any of claims 2-5, wherein the semiconductor device comprises a gate pad (155) and/or a gate wire (156) in the peripheral region of the substrate,
wherein the interlayer source electrode (175) comprises a first insulation structure (1751P1) and a second insulation structure (1751P2),
wherein the first insulation structure (1751P1) is closer to the peripheral region in the first direction and the second direction than the second insulation structure (1751P2) is to the peripheral region, and
wherein an area of the first insulation structure (1751P1) along the first direction and the second direction is less than an area of the second insulation structure (1751P2) along the first direction and the second direction.

7. The semiconductor device of any of claims 2-6, wherein
the plurality of first conductive lines (1752D1) comprise
a plurality of first conductive overlapping lines (1752D1P1), wherein center lines of the plurality of first conductive overlapping lines (1752D1P1) along the second direction overlap with a second portion (171P2) of the first source electrode (171) in the third direction, and
a plurality of first conductive non-overlapping lines (1752D1P2), wherein center lines of the plurality of first conductive non-overlapping lines along the second direction do not overlap with the second portion (171P2) of the first source electrode (171) in the third direction,
wherein a length of each of the plurality of first conductive overlapping lines (1752D1P1) along the second direction is less than a length of each of the plurality of first conductive non-overlapping lines (1752D1P2) along the second direction, and/or the plurality of second conductive lines (1752D2) comprise
a plurality of second conductive overlapping lines (1752D2P2), wherein center lines of the plurality of second conductive overlapping lines (1752D2P2) along the first direction overlap with the second portion (171P2) of the first source electrode (171) in the third direction, and
a plurality of second conductive non-overlapping lines (1752D2P1), wherein center lines of the plurality of second conductive non-overlapping lines (1752D2P1) along the first direction do not overlap with the second portion (171P2) of the first source electrode (171) in the third direction,
wherein a length of each of the plurality of second conductive overlapping lines (1752D2P2) along the first direction is less than a length of each of the plurality of second conductive non-overlapping lines (1752D2P1) along the first direction.

8. The semiconductor device of any preceding claim,
wherein the source electrode (170) comprises
a plurality of second source electrodes (172) above the first source electrode (171), and
a plurality of interlayer source electrodes (175), each of the plurality of interlayer source electrodes (175) comprising (i) a plurality of insulation structures (1751) spaced apart from one another in a first direction parallel to the upper surface of the substrate (110) and (ii) a plurality of conductive lines (1752) between adjacent insulation structures (1751) of the plurality of insulation structures (1751), and disposed between the first source electrode (171) and adjacent second source electrode (172) of the plurality of second source electrodes (172), and
wherein the plurality of the second source electrodes (172) and the plurality of interlayer source electrodes (175) are alternately stacked in a third direction.

9. The semiconductor device of claim 8, wherein the source electrode (170) comprises
2 to 100 layers of the plurality of second source electrodes (172), and
2 to 100 layers of the plurality of interlayer source electrodes (175).

10. The semiconductor device of claim 8 or claim 9, wherein the plurality of insulation structures (1751) are spaced apart in the first direction and in a second direction that is parallel to the upper surface of the substrate (110) and that is different from the first direction,
wherein the plurality of conductive lines (1752) comprise
a plurality of first conductive lines (1752D1) extending in the first direction and spaced apart from one another in the second direction, wherein each insulation structure (1751) of the plurality of insulation structures is interposed between adjacent first conductive lines (1752D1) of the plurality of first conductive lines (1752D1), and
a plurality of second conductive lines (1752D2) extending in the second direction and spaced apart from one another in the first direction, wherein each insulation structure (1751) of the plurality of insulation structures (1751) is interposed between adjacent second conductive lines (1752D2) of the plurality of second conductive lines (1752D2), and
wherein the plurality of first conductive lines (1752D1) intersect with the plurality of the second conductive lines (1752D2).

11. The semiconductor device of claim 10, wherein a length along the second direction of each first conductive line (1752D1) of a first interlayer source electrode of the plurality of the interlayer source electrodes (175) is (i) greater than the length along the second direction of each first conductive line (1752D1) of a second interlayer source electrode positioned above the first interlayer source electrode in the third direction, and (ii) less than a length along the second direction of each first conductive line (1752D1) of a third interlayer source electrode positioned below the first interlayer source electrode in the third direction, or
a length along the first direction of each of second conductive line (1752D2) of the first interlayer source electrode is (i) greater than a length along the first direction of each second conductive line (1752D2) of the second interlayer source electrode, and (ii) less than a length along the first direction of each second conductive line (1752D2) of the third interlayer source electrode, and
a separation distance of adjacent insulation structures (1751) of the plurality of insulation structures (1751) of at least one of the plurality of interlayer source electrodes, along the first direction or the second direction, is (i) greater than a separation distance, along the first direction or the second direction, of adjacent insulation structures (1751) of the plurality of insulation structures (1751) of one or more other interlayer source electrodes that are positioned above the at least one interlayer source electrode in the third direction, and (ii) less than a separation distance, along the first direction or the second direction, of adjacent insulation structures (1751) of the plurality of insulation structures of one or more other interlayer source electrodes that are positioned below the at least one interlayer source electrode in the third direction; or wherein the source electrode (170) comprises:
a 1st interlayer source electrode on the first source electrode (171) and comprising (i) a plurality of insulation structures (1751) spaced apart from one another in the first direction and (ii) a plurality of conductive lines (1752) between the plurality of insulation structures (1751);
a 1st second source electrode on the 1st interlayer source electrode;
a 2nd interlayer source electrode on the 1st second source electrode and comprising (i) a plurality of insulation structures (1751) spaced apart from one another in the first direction and (ii) a plurality of conductive lines (1752) between the plurality of insulation structures;
a 2nd second source electrode on the 2nd interlayer source electrode;
a 3rd interlayer source electrode on the 2nd second source electrode and comprising (i) a plurality of insulation structures (1751) spaced apart from one another in the first direction and (ii) a plurality of conductive lines (1752) between the plurality of insulation structures; and
a 3rd second source electrode on the 3rd interlayer source electrode,
wherein a length of each of the plurality of first conductive lines (1752D1) of the 1st interlayer source electrode along the second direction is greater than a length of each of the plurality of first conductive lines (1752D1) of the 2nd interlayer source electrode along the second direction, and
wherein (i) a length of each of the plurality of first conductive lines (1752D1) of the 2nd interlayer source electrode along the second direction is greater than a length of each of the plurality of first conductive lines (1752D1) of the 3rd interlayer source electrode along the second direction, or (ii) a length of each of the plurality of second conductive lines (1752D2) of the 1st interlayer source electrode along the first direction is greater than a length of each of the plurality of second conductive lines (1752D2) of the 2nd interlayer source electrode along the first direction,
wherein a length of each of the plurality of second conductive lines (1752D2) of the 2nd interlayer source electrode along the first direction is greater than a length of each of the plurality of second conductive lines (1752D2) of the 3rd interlayer source electrode along the first direction,
wherein a separation distance of adjacent ones of the plurality of insulation structures (1751) of the 1st interlayer source electrode along the first direction or the second direction is greater than a separation distance of adjacent ones of the plurality of insulation structures (1751) of the 2nd interlayer source electrode along the first direction or the second direction, and
wherein a separation distance of adjacent ones of the plurality of insulation structures (1751) of the 2nd interlayer source electrode along the first direction or the second direction is greater than a separation distance of adjacent ones of the plurality of insulation structures (1751) of the 3rd interlayer source electrode along the first direction or the second direction.

12. The semiconductor device of any preceding claim,
wherein the source electrode comprises
a 1st interlayer source electrode on the first source electrode (171) and comprising (i) a plurality of insulation structures (1751) spaced apart from one another in a first direction that is parallel to the upper surface of the substrate and (ii) a plurality of conductive lines (1752) disposed between the insulation structures (1751),
a 1st second source electrode on the 1st interlayer source electrode,
a 2nd interlayer source electrode on the 1st second source electrode and comprising (i) a plurality of insulation structures (1751) spaced apart from one another in the first direction and (ii) a plurality of conductive lines (1752) between the plurality of insulation structures (1751),
a 2nd second source electrode on the 2nd interlayer source electrode, and
wherein each of center points of the plurality of insulation structures (1751) of the 1st interlayer source electrode along the first direction and a second direction that is parallel to the upper surface of the substrate (110) and different from the first direction, does not overlap with, in a third direction, each of center points of the plurality of insulation structures (1751) of the 2nd interlayer source electrode along the first direction and the second direction, the third direction being perpendicular to the upper surface of the substrate (110).

13. The semiconductor device of claim 12, wherein the plurality of insulation structures (1751) of the 1st interlayer source electrode are spaced apart from one another in the first direction and the second direction,
wherein the plurality of insulation structures (1751) of the 2nd interlayer source electrode are spaced apart from one another in the first direction and the second direction,
wherein the plurality of conductive lines (1752) comprise
a plurality of first conductive lines (1752D1) extending in the first direction and spaced apart from one another in the second direction, wherein each insulation structure (1751) of the plurality of insulation structures (1751) is interposed between adjacent first conductive lines (1752D1) of the plurality of first conductive lines (1752D1), and
a plurality of second conductive lines (1752D2) extending in the second direction and spaced apart from one another in the first direction, wherein each insulation structure (1751) of the plurality of insulation structures (1751) is interposed between adjacent second conductive lines (1752D2) of the plurality of second conductive lines (1752D2), and
wherein the plurality of first conductive lines (1752D1) intersect with the plurality of the second conductive lines (1752D2).

14. The semiconductor device of claim 13, wherein:
a center point of each insulation structure (1751) of the plurality of insulation structures (1751) of the 1st interlayer source electrode along the first direction and the second direction overlaps with, in the third direction, a center line of each first conductive line (1752D1) of the plurality of first conductive lines (1752D1) of the 2nd interlayer source electrode along the second direction,
a center point of each insulation structure (1751) of the plurality of insulation structures (1751) of the 1st interlayer source electrode along the first direction and the second direction overlaps with, in the third direction, a center line of each second conductive line (1752D2) of the plurality of second conductive lines (1752D2) of the 2nd interlayer source electrode along the first direction,
a center point of each insulation structure (1751) of the plurality of insulation structures (1751) of the 2nd interlayer source electrode along the first direction and the second direction overlaps with, in the third direction, a center line of each first conductive line (1752D1) of the plurality of first conductive lines (1752D1) of the 1st interlayer source electrode along the second direction,
a center point of each insulation structure (1751) of the plurality of insulation structures (1751) of the 2nd interlayer source electrode along the first direction and the second direction overlaps with, in the third direction, a center line of each second conductive line (1752D2) of the plurality of second conductive lines (1752D2) of the 1st interlayer source electrode along the first direction,
a center line of each first conductive line (1752D1) of the plurality of the first conductive lines (1752D1) of the 1st interlayer source electrode along the second direction does not overlap with, in the third direction, a center line of each first conductive line (1752D1) of the plurality of first conductive lines (1752D1) of the 2nd interlayer source electrode along the second direction, and
a center line of each second conductive line (1752D2) of the plurality of the second conductive lines (1752D2) of the 1st interlayer source electrode along the first direction does not overlap with, in the third direction, a center line of each second conductive line (1752D2) of the plurality of second conductive lines (1752D2) of the 2nd interlayer source electrode along the first direction;
or
a center point of each insulation structure (1751) of the plurality of insulation structures (1751) of the 1st interlayer source electrode along the first direction and the second direction overlaps with, in the third direction, a center line of each first conductive line (1752D1) of the plurality of first conductive lines (1752D1) of the 2nd interlayer source electrode along the second direction,
a center point of each insulation structure (1751) of the plurality of insulation structures (1751) of the 1st interlayer source electrode along the first direction and the second direction does not overlap with, in the third direction, a center line of each second conductive line (1752D2) of the plurality of second conductive lines (1752D2) of the 2nd interlayer source electrode along the first direction,
a center point of each insulation structure (1751) of the plurality of insulation structures (1751) of the 2nd interlayer source electrode along the first direction and the second direction overlaps with, in the third direction, a center line of each first conductive line (1752D1) of the plurality of first conductive lines (1752D1) of the 1st interlayer source electrode along the second direction,
a center point of each insulation structure (1751) of the plurality of insulation structures (1751) of the 2nd interlayer source electrode along the first direction and the second direction does not overlap with, in the third direction, a center line of each second conductive line (1752D2) of the plurality of second conductive lines (1752D2) of the 1st interlayer source electrode along the first direction,
a center line of each first conductive line (1752D1) of the plurality of the first conductive lines (1752D1) of the 1st interlayer source electrode along the second direction does not overlap with, in the third direction, a center line of each first conductive line (1752D1) of the plurality of first conductive lines (1752D1) of the 2nd interlayer source electrode along the second direction, and
a center line of each second conductive line (1752D2) of the plurality of the second conductive lines (1752D2) of the 1st interlayer source electrode along the first direction overlaps with, in the third direction, a center line of each second conductive line (1752D2) of the plurality of second conductive lines (1752D2) of the 2nd interlayer source electrode along the first direction;
or
a center point of each insulation structure (1751) of the plurality of insulation structures (1751) of the 1st interlayer source electrode along the first direction and the second direction does not overlap with, in the third direction, a center line of each first conductive line (1752D1) of the plurality of first conductive lines (1752D1) of the 2nd interlayer source electrode along the second direction,
a center point of each insulation structure (1751) of the plurality of insulation structures (1751) of the 1st interlayer source electrode along the first direction and the second direction overlaps with, in the third direction, a center line of each second conductive line (1752D2) of the plurality of second conductive lines (1752D2) of the 2nd interlayer source electrode along the first direction,
a center point of each insulation structure (1751) of the plurality of insulation structures (1751) of the 2nd interlayer source electrode along the first direction and the second direction does not overlap with, in the third direction, a center line of each first conductive line (1752D1) of the plurality of first conductive lines (1752D1) of the 1st interlayer source electrode along the second direction,
a center point of each insulation structure (1751) of the plurality of insulation structures (1751) of the 2nd interlayer source electrode along the first direction and the second direction overlaps with, in the third direction, a center line of each second conductive line (1752D2) of the plurality of second conductive lines (1752D2) of the 1st interlayer source electrode along the first direction,
a center line of each first conductive line (1752D1) of the plurality of the first conductive lines (1752D1) of the 1st interlayer source electrode along the second direction overlaps with, in the third direction, a center line of each first conductive line (1752D1) of the plurality of first conductive lines (1752D1) of the 2nd interlayer source electrode along the second direction, and
a center line of each second conductive line (1752D2) of the plurality of the second conductive lines (1752D2) of the 1st interlayer source electrode along the first direction does not overlap with, in the third direction, a center line of each second conductive line (1752D2) of the plurality of second conductive lines (1752D2) of the 2nd interlayer source electrode along the first direction.

15. The semiconductor device of claim 12, wherein the plurality of insulation structures (1751) of the 1st interlayer source electrode extend in the second direction and are spaced apart from one another in the first direction, and the plurality of conductive lines (1752) of the 1st interlayer source electrode comprise a plurality of first conductive lines (1752D2) that (i) extend in the second direction and (ii) are spaced apart from one another in the first direction, wherein each insulation structure (1751) of the plurality of insulation structures (1751) is interposed between adjacent first conductive lines (1752D2) of the plurality of first conductive lines (1752D2), and
wherein adjacent insulation structures (1751) of the plurality of insulation structures (1751) of the 2nd interlayer source electrode are spaced apart from one another in the first direction and the second direction, and the plurality of conductive lines (1752) of the 2nd interlayer source electrode comprise (i) first conductive lines (1752D1) that extend in the first direction and that are spaced apart from one another in the second direction, wherein each insulation structure (1751) of the plurality of insulation structures (1751) is interposed between adjacent first conductive lines (1752D1) of the plurality of first conductive lines (1752D1), and (ii) a plurality of second conductive lines (1752D2) that extend in the second direction and that are spaced apart from one another in the first direction, wherein the plurality of insulation structures (1751) are positioned between the plurality of second conductive lines (1752D2), and wherein the first conductive lines (1752D1) intersect with the second conductive lines (1752D2),
wherein a center line of each insulation structure (1751) of the plurality of insulation structures (1751) of the 1st interlayer source electrode along the first direction overlaps with, in the third direction, a center line of each first conductive line (1752D1) of the plurality of first conductive lines (1752D1) of the 2nd interlayer source electrode along the second direction,
wherein a center line of each insulation structure (1751) of the plurality of insulation structures (1751) of the 1st interlayer source electrode along the first direction overlaps with, in the third direction, a center line of each second conductive line (1752D2) of the plurality of second conductive lines (1752D2) of the 2nd interlayer source electrode along the first direction,
wherein a center point of each insulation structure (1751) of the plurality of insulation structures (1751) of the 2nd interlayer source electrode along the first direction and the second direction overlaps with, in the third direction, a center line of each first conductive line (1752D2) of the plurality of first conductive lines (1752D2) of the 1st interlayer source electrode along the second direction, and
wherein a center line of each first conductive line (1752D2) of the plurality of the first conductive lines (1752D2) of the 1st interlayer source electrode along the first direction does not overlap with, in the third direction, a center line of each second conductive line (1752D2) of the plurality of second conductive lines (1752D2) of the 2nd interlayer source electrode along the first direction.
